# EUROPEAN PATENT APPLICATION

(11) **EP 4 567 778 A1**
(43) Date of publication of application: **11.06.2025**
(21) Application number: 22955075.1
(22) Date of filing: 09.08.2022
(51) Int. Cl.: G09F 19/12, G09F 9/33, G09G 3/34, G02F 1/139

(54) **ARTIFICIAL SKY SIMULATION APPARATUS AND GENERATION METHOD**

(71) Applicant: LG Electronics Inc., Yeongdeungpo-gu Seoul 07336 (KR)
(72) Inventor: LEE, Hyunhee, Seoul 06772 (KR); HWANG, Hyokune, Seoul 06772 (KR); KIM, Namyoung, Seoul 06772 (KR); LEE, Hophil, Seoul 06772 (KR); YOUN, Jekwang, Seoul 06772 (KR); CHOI, Jungeun, Seoul 06772 (KR); PARK, Misun, Seoul 06772 (KR); LEE, Chulbae, Seoul 06772 (KR)
(74) Representative: Vossius & Partner Patentanwälte Rechtsanwälte mbB
(86) International application number: PCT/KR2022/011823
(87) International publication number: WO 2024/034700

(57) **Abstract**

The present invention relates to an apparatus and a method for generating a virtual environment having a simulated artificial sky, the present invention comprising: a transparent display unit for displaying one or more sky images; a light source unit comprising a directional light source having a predetermined radiation angle; a reflective mirror disposed on the rear surface of the transparent display unit and formed so as to reflect light radiated from the light source; and a control unit for controlling the transparent display unit so as to display a sky image selected among the one or more sky images by a user, and controlling the light source unit so as to change the intensity and color temperature of the light source in accordance with the selected sky image.

## Description

### Technical Field

The present disclosure relates to an apparatus and method for generating a virtual environment simulating an artificial sky.

### Background Art

At present, optical technologies such as LEDs and displays are developing significantly. Accordingly, interest is increasing in lighting interiors that provide diverse visual effects using the optical technologies and optical apparatuses rather than simple lighting.

As part of the interest, artificial sky has emerged that provides the same visual effect as looking at the sky through a real window. The artificial sky may convey to a user the feeling of a real sky by displaying a natural image of the sky with a uniform brightness on part of the ceiling or wall using an LED panel or display.

Meanwhile, as a conventional method for generating such an artificial sky, a method of installing an LCD or LED display on a part of the ceiling or wall and outputting a image such as the sky through the installed display has been used. However, such a method uses the display as a light source, so there is a problem in that the brightness as a light source is not sufficient, and if the brightness is increased too much, the brightness of the image itself displayed on the display increases, which is different from the actual natural sky. That is, even though the image is of a cloudy sky, the brightness of the clouds themselves increases. In this case, if the color of the clouds is not bright (for example, gray), there is a difficulty in that the brightness is limited due to the color of the image displayed on the display.

In order to solve those problems and generate a more natural artificial sky, a simulation apparatus that simulates a structure of an actual atmospheric layer has emerged. The simulation apparatus simulates natural light (sunlight) by using a panel that causes Rayleigh scattering, and forms an atmospheric layer that compresses the Earth's atmospheric layer into an ultra-fine space by using a nano-diffuser. For such a simulation apparatus, a panel is used to generate Rayleigh scattered light like sunlight, and the generated Rayleigh scattered light is transmitted through an artificial atmospheric layer that replicates the actual structure of the Earth's atmospheric layer. In this manner, an artificial sky using a nano-diffuser and a Rayleigh scattering panel may realistically simulate a perspective of light, a shadow from light, and the like, as scattered light transmitted through the artificial atmospheric layer, so it has an advantage capable of simulating an artificial sky similar to a natural sky.

However, such a simulation apparatus has a problem in that expensive nano-diffuser and Rayleigh scattering panel are required. As a result, there is a problem in that it requires a very high cost. Moreover, since a space is required to form the atmospheric layer, there is a problem in that a thick space of about 1 m is required to form the atmospheric layer. Moreover, the simulation apparatus only simulates the atmospheric layer and the sun in a clear state, and has a problem in that it is difficult to simulate any state other than a state with sunlight shining against a blue sky background.

### Disclosure of Invention

### Technical Problem

The present disclosure aims to solve the foregoing problems and other problems, and an aspect of the present disclosure is to provide a more realistic artificial sky simulation apparatus and simulation method that can simulate the characteristics of a natural sky, such as a perspective of light, a shadow from light, and the like, at a lower cost.

In addition, an aspect of the present disclosure is to provide an artificial sky simulation apparatus and simulation method that can simulate a natural sky according to various weather conditions according to a user's request.

In addition, an aspect of the present disclosure is to provide an artificial sky simulation apparatus and simulation method that can simulate various atmospheric conditions according to a date and time specified by a user for various regions.

In addition, an aspect of the present disclosure is to provide an artificial sky simulation apparatus and simulation method that can simulate an atmospheric environment around a user according to a simulated sky based on a specified weather condition or any one of a specified region, date, and time.

### Solution to Problem

In order to achieve the foregoing or other objectives, according to an aspect of the present disclosure, an artificial sky simulation apparatus according to an embodiment of the present disclosure may include a transparent display unit that displays at least one sky image, a light source unit including a directional light source having a preset radiation angle, a reflective mirror disposed on a rear surface of the transparent display unit to reflect light emitted from the light source, and a control unit that controls the transparent display unit to display a sky image selected by a user from among the at least one sky image, and controls the light source unit to change the brightness and color temperature of the light source according to the selected sky image.

In one embodiment, the light source unit may further include a drive unit disposed to move the light source in a preset direction, wherein the drive unit includes a rail disposed in the preset direction, a mount mounted with the light source to face the reflective mirror, and disposed to fix the mounted light source, and at least one wheel disposed to allow the mount to move on the rail and at least one drive motor to drive the wheel.

In one embodiment, the drive unit may further include a light source unit frame disposed to receive and support the light source and the drive unit, wherein the light source unit frame includes a plurality of guide frames disposed to extend along the preset direction, and a mount frame disposed to allow the plurality of guide frames to move along an extended direction and coupled to the mount.

In one embodiment, the control unit may calculate a position of the sun according to at least one of a selected sky image, a selected time, and a selected region, and move a position of the light source according to the calculated position of the sun.

In one embodiment, the transparent display unit may be configured to be received in a display housing unit disposed to receive and support the transparent display unit, be disposed with a hole of a size corresponding to at least part of a front surface of the transparent display unit to expose at least part of the front surface of the transparent display unit on a lower surface of the display housing unit, and be disposed with the reflective mirror extending along an upper surface of the display housing unit, and facing a rear surface of the transparent display unit on an inner side of the upper surface facing the lower surface of the display housing unit.

In one embodiment, at least part of side surfaces of the display housing unit is provided with a light shield disposed to extend each side surface of the display housing unit.

In one embodiment, each inner surface of the display housing unit may be coated with a blackout layer not to expose a shape of the inner surface.

In one embodiment, the apparatus may further include a polarizing filter disposed between the transparent display unit and the reflective mirror to transmit polarized light in a first direction, and a liquid crystal layer disposed between the polarizing filter and the reflective mirror to transmit light depending on whether a preset voltage is applied thereto.

In one embodiment, one side of the reflective mirror may be disposed to be inclined at a predetermined angle inward the display housing.

In one embodiment, the light source unit may be received in a light source housing unit disposed to receive and support the light source, wherein the light source housing unit further includes at least one auxiliary reflective mirror disposed to reflect incident light at a specified reflection angle on the reflective mirror when light radiated from the light source is incident thereon.

In one embodiment, the apparatus may further include an audio output unit disposed to output an audio signal corresponding to a sky image selected by the user, wherein the audio signal corresponding to the selected sky image is an audio signal in which a plurality of different audio signals are combined differently in at least one of an output order and a delay time according to the user's selection.

In one embodiment, the apparatus may further include a communication unit for controlling at least one peripheral device capable of adjusting temperature, humidity and wind of an indoor space in which the artificial sky simulation apparatus is disposed, wherein the control unit controls at least one peripheral device to change at least one of the temperature, humidity, and wind of the indoor space according to a sky image selected by the user.

In one embodiment, the control unit may control, when a specific region is selected, the transparent display unit to acquire a current weather condition of the specific region, and output a sky image corresponding to the acquired weather information, and control at least one peripheral device to change at least one of temperature, humidity and wind of the indoor space based on weather information of the specific region.

In one embodiment, a sky image corresponding to the weather information of the specific region may include at least part of a landmark of the specific region.

In one embodiment, the control unit may calculate a difference between at least one of temperature, humidity, and wind speed according to weather information of the specific region, and at least one of temperature, humidity, and wind speed of the indoor space, and determine a control level for controlling the at least one peripheral device by reducing the calculated difference according to a preset reduction ratio.

In one embodiment, the control unit may calculate, when the user selects a specific time, a solar altitude corresponding to the selected time in the specific region based on the selected time and a latitude of the specific region, and control the at least one peripheral device to change at least one of the temperature, humidity, and wind of the indoor space according to the calculated solar altitude.

In order to achieve the foregoing or other objectives, according to an aspect of the present disclosure, a method of controlling an artificial sky simulation apparatus including a directional light source and a transparent display unit disposed to transmit light from the light source according to an embodiment of the present disclosure may include outputting a selected specific sky image to the transparent display unit , changing at least one of the brightness and color temperature of the light source according to the specific sky image, changing a position at which light from the light source is transmitted through the transparent display unit based on the specific sky image, outputting an audio signal corresponding to the specific sky image, and controlling at least one peripheral device based on the specific sky image to change at least one of temperature, humidity, and wind of an indoor space in which the artificial sky simulation apparatus is installed.

In one embodiment, the outputting of the specific sky image may include selecting a specific region from a user, and outputting a sky image corresponding to the selected region as the specific sky image, wherein the changing of at least one of the temperature, humidity, and wind includes calculating a solar altitude corresponding to a time selected by the user according to a latitude of the specific region, and controlling the at least one peripheral device to change at least one of the temperature, humidity, and wind of the indoor space according to the calculated solar altitude.

In one embodiment, the outputting of the specific sky image may include selecting a specific region from a user, and outputting a sky image corresponding to the selected region as the specific sky image, wherein the changing of at least one of the temperature, humidity, and wind includes detecting a current weather condition of the specific region, calculating a difference between the current weather condition of the detected specific region and at least one of the temperature, humidity, and wind of the indoor space, determining a control level to control at least one of the temperature, humidity, and wind according to the calculated difference and a preset reduction ratio, and controlling the at least one peripheral device according to the determined control level to change at least one of the temperature, humidity, and wind of the indoor space.

### Advantageous Effects of Invention

An artificial sky simulation apparatus and simulation method according to the present disclosure are described as follows.

According to at least one of embodiments of the present disclosure, instead of a nano-diffuser and a Rayleigh scattering panel, an image of a natural sky may be output through transparent organic light emitting diodes (TOLED) and light from a light source reflected through a reflective mirror may be transmitted through the TOLED so as to provide a perspective when the sun transmits through the atmosphere to irradiate a window, and a shadow from the window due to the light source, thereby simulating natural light actually transmitted through the window and the sky. Therefore, the present disclosure has an effect that can simulate a more realistic artificial sky having the characteristics of a natural sky, such as a perspective of light, a shadow, and the like, at a lower cost.

In addition, the present disclosure may output an image of the sky corresponding to at least one of a weather condition, a specific position, a date and time according to a user's request through the TOLED, and allow light from a light source reflected through a reflective mirror to transmit through the TOLED, thereby having an effect of simulating the sky corresponding to at least one of the a weather condition, a specific position, a date and time according to the user's request.

In addition, the present disclosure may control at least one peripheral apparatus that can adjust the air condition around a user according to the sky simulated based on any one of a specified weather condition or a specified region, and a date and time, thereby having an effect of simulating an atmospheric environment around the user according to the simulated sky.

### Brief Description of Drawings

FIG. 1 is a block diagram showing a structure of an artificial sky simulation apparatus according to an embodiment of the present disclosure.
FIG. 2 is exemplary views showing a cross-sectional view and a perspective view of an artificial sky simulation apparatus according to an embodiment of the present disclosure.
FIG. 3 is a perspective view showing a structure of a display housing unit and a light source housing unit constituting the artificial sky simulation apparatus.
FIG. 4 is an assembly view showing a structure of the display housing unit in more detail.
FIG. 5 is an exemplary view showing an example of controlling, by an artificial sky simulation apparatus according to an embodiment of the present disclosure, at least one peripheral device.
FIG. 6 is a flowchart showing an operation process of simulating, by an artificial sky simulation apparatus according to an embodiment of the present disclosure, the sky and atmospheric environment corresponding to a weather condition selected by a user.
FIG. 7 is a flowchart showing an operation process of simulating, by an artificial sky simulation apparatus according to an embodiment of the present disclosure, the sky and atmospheric environment according to a region, a season, and a time selected by a user.
FIG. 8 is a flowchart showing an operation process of simulating, by an artificial sky simulation apparatus according to an embodiment of the present disclosure, the sky and atmospheric environment according to a current weather condition and a time in a specific region at a user's request.
FIG. 9 is a flowchart showing an operation process of adjusting, by an artificial sky simulation apparatus according to an embodiment of the present disclosure, an atmospheric environment around the user according to an indoor atmospheric condition and an atmospheric environment to be simulated.
FIG. 10 is an exemplary view for explaining an example of simulating, by an artificial sky simulation apparatus according to an embodiment of the present disclosure, the sky and its resultant atmospheric environments according to different times.
FIG. 11 is an exemplary view for explaining an example of simulating, by an artificial sky simulation apparatus according to an embodiment of the present disclosure, the sky and atmospheric environments corresponding to different weather conditions and different regions.
FIG. 12 is an assembly view showing a second embodiment of an artificial sky simulation apparatus according to an embodiment of the present disclosure in which a display receiving unit and a light source receiving unit have different shapes, and a structure of the artificial sky simulation apparatus according to the second embodiment.
FIG. 13 is an assembly view showing a structure of a fixed frame including a light source unit and a drive unit disposed to move the light source unit in the artificial sky simulation apparatus according to the second embodiment.
FIG. 14 is an exemplary view showing a brightness of transmitted light transmitted through a display unit and a change in the amount of transmitted light according to the movement of the light source unit in an artificial sky simulation apparatus according to the second embodiment.
FIG. 15 is an exemplary view showing an example of a liquid crystal formed to transmit light depending on whether power is supplied between TOLED and a reflective mirror in an artificial sky simulation apparatus according to an embodiment of the present disclosure.
FIG. 16 is an exemplary view showing a difference in a shape of transmitted light and an irradiation area formed when a light source and natural light transmit through TOLED in an artificial sky simulation apparatus according to an embodiment of the present disclosure.
FIGS. 17 and 18 are exemplary views showing structures that allow light closer to sunlight to be formed by further using at least one reflective mirror in an artificial sky simulation apparatus according to an embodiment of the present disclosure.
FIG. 19 is an exemplary view showing an example of a configuration including a polarizing plate and a wave plate to prevent multiple reflections occurring between reflective mirrors in an artificial sky simulation apparatus.

### Mode for the Invention

It should be noted that technical terms used herein are merely used to describe a specific embodiment, but not to limit the present disclosure. In addition, a singular expression used herein may include a plural expression unless clearly defined otherwise in the context. A suffix "module" or "part" used for elements disclosed in the following description is merely intended for easy description of the specification, and the suffix itself is not intended to have any special meaning or function.

As used herein, terms such as "comprise" or "include" should not be construed to necessarily include all elements or steps described herein, and should be construed not to include some elements or some steps thereof, or should be construed to further include additional elements or steps.

In addition, in describing technologies disclosed herein, when it is determined that a detailed description of known technologies related thereto may unnecessarily obscure the subject matter disclosed herein, the detailed description will be omitted.

Furthermore, the accompanying drawings are provided only for a better understanding of the embodiments disclosed in this specification and are not intended to limit technical concepts disclosed in this specification, and therefore, it should be understood that the accompanying drawings include all modifications, equivalents and substitutes within the concept and technical scope of the present disclosure. In addition, not only respective embodiments described below, but also combinations of embodiments can of course be included within the concept and technical scope of the present disclosure as modifications, equivalents or substitutes.

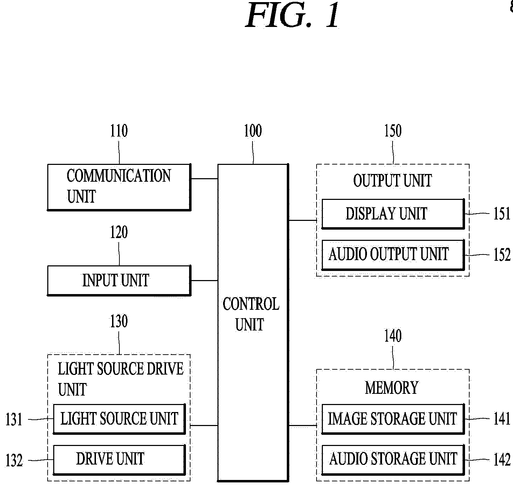

FIG. 1 is a block diagram showing a structure of an artificial sky simulation apparatus according to an embodiment of the present disclosure.

Referring to FIG. 1, an artificial sky simulation apparatus according to an embodiment of the present disclosure may include a control unit 100, a communication unit 110 connected to the control unit 100, an input unit 120, a light source drive unit 130, an output unit 150, and a memory 140. The elements shown in FIG. 1 are not essential for implementing the artificial sky simulation apparatus, and thus the artificial sky simulation apparatus described herein may have more or fewer elements than those listed above.

First, the communication unit 110 may include one or more modules that allows wireless communication between the artificial sky simulation apparatus and a wireless communication system, between the artificial sky simulation apparatus and at least one peripheral device, or between the artificial sky simulation apparatus and an external server. In addition, the communication unit 110 may include one or more modules for connecting the artificial sky simulation apparatus to one or more networks.

The module included in the communication unit 110 may include a wireless Internet module. The wireless Internet module refers to a module for wireless Internet access, which may be built into or external to the artificial sky simulation apparatus. The wireless Internet module may be configured to transmit and receive a wireless signal in a communication network according to wireless Internet technologies.

The wireless Internet technologies may include, for example, wireless LAN (WLAN), wireless-fidelity (Wi-Fi), wireless-fidelity direct (Wi-Fi Direct), digital living network alliance (DLNA), wireless broadband (WiBro), worldwide interoperability for microwave access (WiMAX), high speed downlink packet access (HSDPA), high speed uplink packet access (HSUPA), long term evolution (LTE), long term evolution-advanced (LTE-A), and the like, and may also include Internet technologies not listed above. Furthermore, data may be transmitted and received according to at least one wireless Internet technology in a range not listed above.

Furthermore, the module included in the communication unit 110 may include a short-range communication module. The short-range communication module is configured to facilitate short-range communication, which can support short-range communication using at least one of Bluetooth^{™}, radio frequency identification (RFID), infrared data association (IrDA), ultra wideband (UWB), ZigBee, near field communication (NFC), wireless-fidelity (Wi-Fi), Wi-Fi direct, wireless universal serial bus (wireless USB) technologies, and the like. The short-range communication module may support wireless communication between an artificial sky simulation apparatus and a wireless communication system, and between an artificial sky simulation apparatus and at least one other peripheral device via wireless area networks.

Next, the input unit 120 is configured to input information that is input from a user,
which may include a remote controller including at least one of a mechanical input element, such as at least one button or dome switch, a jog wheel, a jog switch, or the like, and a touch-sensitive input element. The remote controller may be an apparatus implemented exclusively for the artificial sky simulation apparatus, or may be a terminal having an application related to a user input function installed.

In this case, the terminal may include a user's mobile phone, a smart phone, a laptop computer, a personal digital assistant (PDA), a portable multimedia player (PMP), a navigation, a slate PC, a tablet PC, an ultrabook, a wearable device (e.g., smartwatch, smart glasses, head mounted display (HMD)), or the like.

In this case, the terminal may receive an input from a user operating the terminal as an input to the artificial sky simulation apparatus through an application related to a user input function. Furthermore, the received user input may be transmitted to the control unit 100, thereby operating the artificial sky simulation apparatus according to the user input.

Furthermore, the light source drive unit 130 may be disposed to include a light source unit 131 and a drive unit 132 disposed to move a position of the light source unit 131. The light source unit 131 may be a light source capable of emitting light above a predetermined level when power is applied thereto, and may be a directional light having a radiation angle within a preset level. As an example, the light source may be a concentrated LED light having a radiation angle of 30 to 60 degrees.

Additionally, the drive unit 132 may include a mechanism disposed to move the light source unit 131 in one direction. For example, the drive unit 132 may include a rail extending in the one direction, a mount disposed to mount the light source unit 131, at least one wheel disposed to move the mount in the one direction on the rail, and a drive motor. In addition, the drive unit 132 may include a support unit that can support the light source unit 131, so as to prevent shaking of the light source unit 131 mounted on the mount even when the light source unit 131 moves.

Meanwhile, the light source drive unit 130 may be disposed so that the light can be irradiated to a rear surface of the display unit 151. As an example, the light source drive unit 130 may be disposed so as to face a rear surface of the display unit 151 or may be disposed so as to face a reflective mirror facing the rear surface of the display unit 151.

Here, the reflective mirror may be disposed to face the rear surface of the display unit 151 so as to further extend a light reaching distance at which light emitted from the light source unit 131 reaches the rear surface of the display unit 151. In this case, the light emitted from the light source unit 131 may be totally reflected by the reflective mirror and irradiated to the rear surface of the display unit 151.

Meanwhile, the output unit 150 may include the display unit 151 for displaying image information and an audio output unit 152 for outputting audio information. Here, the display unit 151 may be a transparent display apparatus having a predetermined level of light transmittance or higher so as to allow light from the light source unit 131 irradiated to the rear surface to be transmitted therethrough. As an example, the display unit 151 may be a transparent LCD display, and may preferably be implemented as TOLED. Therefore, the light from the light source unit 131 irradiated to the rear surface of the display unit 151 may transmit through the display unit 151.

Then, transmitted light that is transmitted through the display unit 151 may be irradiated through the front surface of the display unit 151. In this case, when an image object output from the display unit 151 has a shape, such as a cloud, tree, or leaf, the transmission of the light may be limited, thereby causing a shadow to be formed. In addition, a shadow by the window may be formed. Thus, a shadow from a window, or a shadow formed by a tree, cloud, or leaf, may be formed, and transmitted light similar to sunlight that is actually transmitted through a window may be simulated.

Additionally, satin glass may be laminated on the rear surface of the display 151. The satin glass may provide a foggy effect, and thus an LED light of the light source unit 131 may be shone to be round like the sun. In addition, polarizing glass may be further laminated on the display 151 to improve a phenomenon of light spreading in a cross shape.

In the following description, for convenience of explanation, it is assumed that the display unit 151 is implemented as TOLED. However, the present disclosure is not, of course, limited thereto.

Meanwhile, the display unit 151 may output an image of the sky corresponding to a weather condition, a region, a season, a date, or a specific time selected by the user under the control of the control unit 100. In this case, light from the light source unit 131 may transmit through the display unit 151 on which an image of the sky is displayed. Accordingly, sunlight transmitted through an atmospheric condition corresponding to the selected weather condition or region, season or date, or specific time may be simulated, and a perspective of the sunlight and a shadow effect caused by transmitted light that is transmitted through the display unit 151 may be simulated. That is, an artificial sky that simulates a natural sky corresponding to the selected weather condition or region, season or date, or specific time may be output.

Meanwhile, the audio output unit 152 may output an audio signal according to the sky image output from the display unit 151. For example, when the sky image being output is an image of the morning sky, an audio signal such as a chirping sound of a bird may be output. Additionally, when the output sky image is an image of the night sky, an audio signal that can be heard in the evening, such as the sound of crickets or grasshoppers, may be output. In addition, when the output sky image is an image of a thunderstorm with rainstorm or thunder or lightning, the sound of rain and the sound of thunder may be output as an audio signal. Each of those different sky images may be preset to correspond to at least one different audio signal.

The memory 140 may store various data for the operation of the control unit 100. As an example, the memory 140 may store an application or program and instructions for driving and controlling other components connected to the control unit 100. In addition, data related to a plurality of sky images to be output through the display unit 151 and at least one audio signal data corresponding to each sky image may be stored. Hereinafter, an area on the memory 140 where data related to the sky image is stored will be referred to as an image storage unit 141, and an area on the memory 140 where the audio signal data is stored will be referred to as an audio storage unit 142.

Furthermore, the control unit 100 may control an overall operation of the artificial sky simulation apparatus according to an embodiment of the present disclosure, and control connected components. For example, the control unit 100 may select at least one of a specific region, a specific season or date, and a specific time based on a user input applied through the input unit 120, and may select any one sky image stored on the image storage unit 141 based on at least one of the selected region, season, date, and time. Alternatively, the user may select any one sky image corresponding to a specific weather condition selected by the user. Furthermore, based on at least one of the selected weather condition or region, season or date, and time, the position of the sun may be calculated, and the drive unit 132 may be controlled to move the light source unit 131 according to the calculated position of the sun. Furthermore, the light source unit 131 may be controlled to emit light according to the color temperature and illuminance determined by at least one of the weather condition, region, season, date, and time. In this case, the light source unit 131 may simulate the sun corresponding to at least one of the selected weather condition, region, season, or date and time.

In addition, when a sky image is selected, the control unit 100 may detect at least one audio signal corresponding to the selected sky image from the audio storage unit 142. Furthermore, the audio output unit 152 may be controlled to output at least one detected audio signal while at the same time controlling the display unit 151 to output the selected sky image. Accordingly, light from the light source unit 131 may be transmitted through the display unit 151, that is, the transparent display apparatus, on which the sky image is output. Furthermore, the transmitted light may be irradiated through the front surface of the display unit 151 to perform the function of lighting. In this case, the transmitted light, which is emitted from the light source unit 131, may have a sufficient brightness and amount of light that can be used as lighting.

Furthermore, the control unit 100 may control at least one air conditioning apparatus through the communication unit 110. As an example, the control unit 100 may control the humidifier to change an indoor humidity to a humidity corresponding to at least one of the weather condition, region, season, date, and time selected by the user. In this case, when the humidifier is an aroma humidifier, the aroma humidifier may be controlled to output a specific scent corresponding to the sky image output along with a change in the indoor humidity.

In addition, the control unit 100 may further control an air conditioner or an air cleaner. In this case, the air conditioner or air purifier may replace the humidifier through its humidifying function. Additionally, the air conditioner may change an indoor temperature to a temperature corresponding to at least one of the weather condition, region, season, or date and time selected by the user. In addition, based on the sky image, the control unit 100 may control the air conditioner or air purifier so as to form a wind speed corresponding to the selected sky image. As an example, when the output sky image is a clear sky image or a thunderstorm image, the air conditioner or air purifier may be controlled so as to form wind with a strong wind speed. On the contrary, when the output sky image is a morning sky image or a night sky image, the air conditioner or air purifier may be controlled so as to form wind with a weak wind speed.

Meanwhile, the control unit 100 may calculate a position of the sun corresponding to a region, season or date selected over time. Furthermore, the light source may be moved depending on the calculated position of the sun. Therefore, the artificial sky simulation apparatus according to an embodiment of the present disclosure may simulate a position of the sun moving over time by determining the position of the sun moving over time in a selected region, season, or date, and moving a light source according to the determined position of the sun.

Additionally, the sky image output through the display unit 151 may be changed depending on the position of the sun being simulated. As an example, when a simulation of an artificial sky in the morning is requested from the user, the display unit 151 may output a sky image corresponding to the morning sky on the display unit 151, and control a peripheral device so as to form temperature, humidity, and wind speed according to the output sky image (morning sky image). Furthermore, when time passes while the artificial sky is being simulated, the position of the light source may be gradually moved over time to simulate the movement of the sun, and control a peripheral device to gradually change temperature, humidity, and wind speed according to the simulated position of the sun.

That is, when the artificial sky is output in the morning and the output of the artificial sky is maintained until the afternoon, the control unit 100 may gradually change the sky image output from the sky image corresponding to the "morning sky" to the sky image corresponding to the "clear sky" over time.

Meanwhile, the temperature corresponding to the "clear sky" may be higher than that corresponding to the "morning sky." In addition, the humidity corresponding to the "clear sky" may be lower than that corresponding to the "morning sky." Additionally, the wind speed corresponding to the "clear sky" may be stronger than that corresponding to the "morning sky." Accordingly, the control unit 100 may gradually increase the temperature (e.g., stop an operation of the air conditioner) or decrease the humidity when the sky image corresponding to the "morning sky" is gradually changed to the sky image corresponding to the "clear sky." In addition, an amount of wind output from the air conditioner or air purifier may be increased.

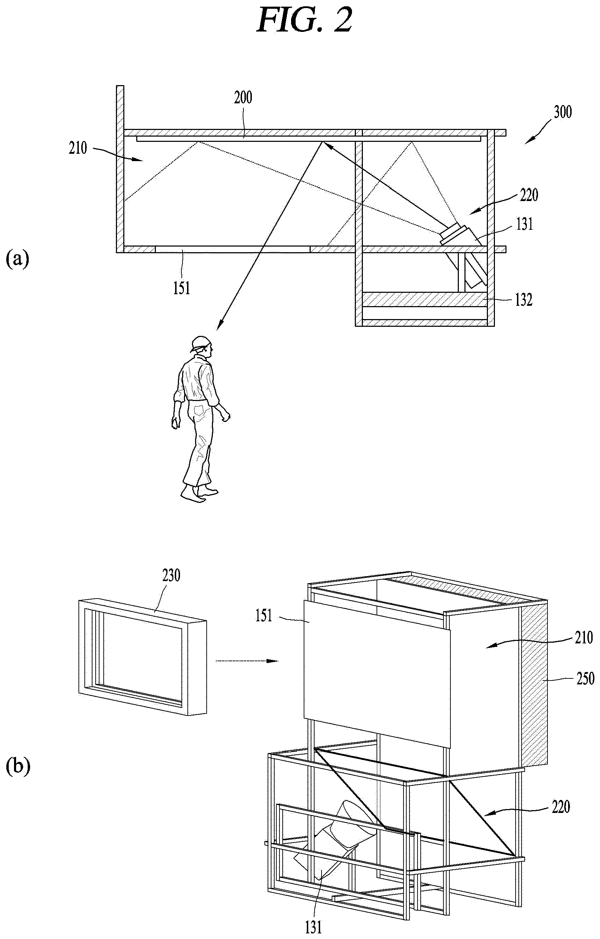

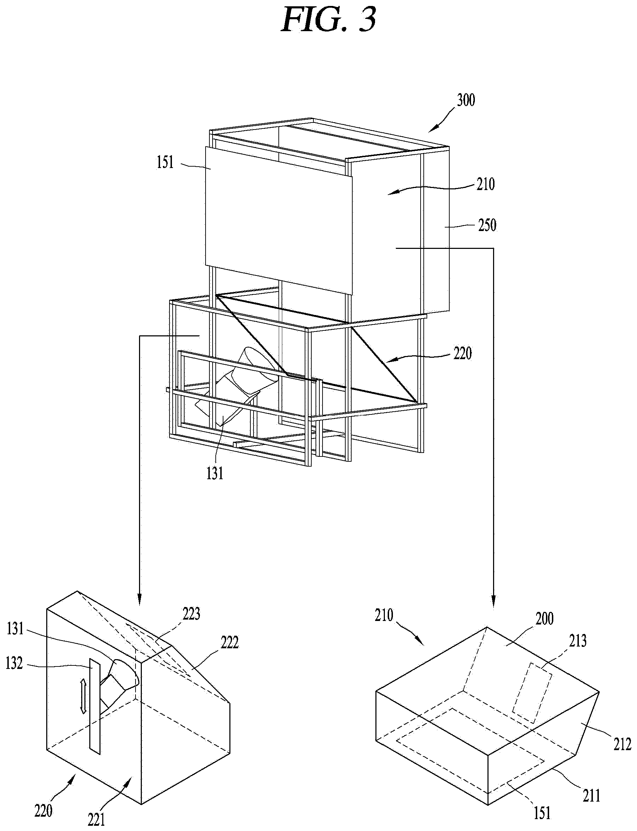

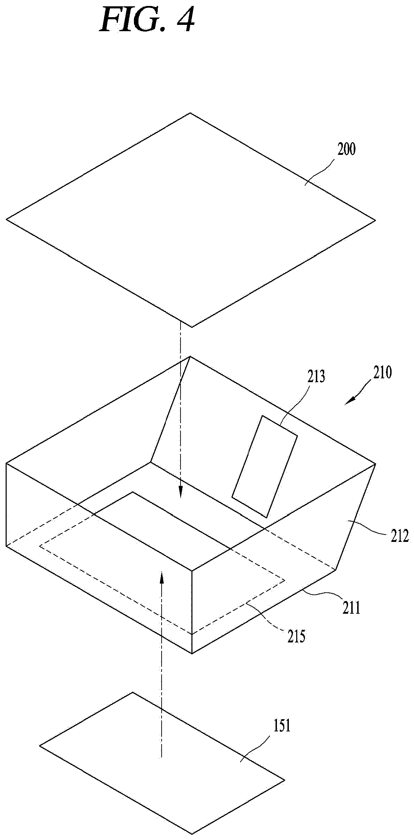

FIG. 2 is an exemplary view showing a cross-sectional view and a perspective view of an artificial sky simulation apparatus 300 according to such an embodiment of the present disclosure. Furthermore, FIG. 3 is a perspective view showing a structure of the display housing unit 210 and the light source housing unit 220 that constitute the artificial sky simulation apparatus 300. Furthermore, FIG. 4 is an assembly view showing a structure of the display housing unit 210 in more detail.

First, referring to (a) of FIG. 2, the artificial sky simulation apparatus 300 may be disposed on a ceiling portion in an indoor space. Furthermore, a display housing unit 210 disposed to receive and support the display unit 151 may be provided. The display housing unit 210 may have a display unit 151 disposed on one surface facing the user, and a hole of a size corresponding to an area of a front surface portion of the display unit 151 may be disposed on the one surface so as to expose the front surface portion of the disposed display unit 151.

Meanwhile, a reflective mirror 200 disposed to face a rear surface of the display unit 151 may be provided on an inner side of the other surface of the display housing unit 210. In addition, the reflective mirror 200 may be disposed to extend along the inner side of the other surface of the display housing unit 210.

Therefore, when light is reflected on the reflective mirror 200, the reflected light may be irradiated to the rear surface of the display unit 151, and may be irradiated to the front surface of the display unit 151 by transmitting through the display unit 151. Hereinafter, the front surface of the display unit 151 in the artificial sky simulation apparatus 300 disposed on a ceiling portion of the indoor space is disposed to face the user, and thus one surface of the display housing unit 210 where the display unit 151 is disposed and the other surface of the display housing unit 210 where the reflective mirror 200 is disposed on an inner side thereof are referred to as lower and upper surfaces of the display housing unit 210, respectively.

Furthermore, surfaces of the display housing unit 210 disposed in a direction perpendicular to the upper and lower surfaces are referred to as side surfaces. Here, one of the side surfaces of the display housing unit 210 may be a contact surface that comes into contact with the light source housing unit 220 that receives and supports the light source unit 131.

Meanwhile, the contact surface of the display housing unit 210 may have a light passage groove disposed to allow light irradiated from the light source unit 131 received in the light source housing unit 220 to pass therethrough so as to enter the display housing unit 210. In this case, the light source unit 131 may be disposed to face the light passage groove, and thus light from the light source unit 131 may be irradiated into the display housing unit 210 through the light passage groove. Furthermore, the irradiated light may be reflected by the reflective mirror 200 and irradiated to the rear surface of the display unit 151.

Meanwhile, as described above, the light source unit 131 may be disposed to face a preset reflection angle so as to allow light from the light source unit 131 to be reflected by the reflective mirror 200 and irradiated to the rear surface of the display unit 151. Therefore, as shown in (a) of FIG. 2, the light source unit 131 may be disposed to face a direction inclined according to the reflection angle.

Since the light source unit 131 is disposed to face a direction inclined along the reflection angle, a contact surface of the display housing unit 210 that comes into contact with the light source housing unit 220 may form an inclined surface. Furthermore, the light passage groove may be disposed along the inclined surface. Furthermore, an inclined angle (first acute angle) formed by the contact surface 212 of the display housing unit 210 with respect to the upper surface may be an angle that forms a direction perpendicular to a direction facing the light source unit 131.

Meanwhile, as the contact surface 212 of the display housing unit 210 forms an inclined surface, a contact surface 222 of the light source housing unit 220 that comes into contact with the contact surface 212 of the display housing unit 210 may also form an inclined surface. Furthermore, the same light passage groove corresponding to the light passage groove disposed on the contact surface of the display housing unit 210 may be disposed.

Therefore, as shown in (a) of FIG. 2, the contact surface 212 of the display housing unit 210 and the contact surface 222 of the light source housing unit 220 may be connected to each other. Furthermore, through a light passage groove disposed in common on a contact surface of the display housing unit 210 and a contact surface of the light source housing unit 220, light from the light source unit 131 received in the light source housing unit 220 may be irradiated to the display housing unit 210.

Here, an inclined angle (second acute angle) of the contact surface 222 of the light source housing unit 220 may be complementary with respect to an inclination angle of the contact surface 212 of the display housing unit 210, that is, the first acute angle. Therefore, when the contact surface 212 of the display housing unit 210 and the contact surface 222 of the light source housing unit 220 are connected to each other, the display housing unit 210 and the light source housing unit 220 may be connected to each other at a right angle, as shown above in (a) of FIG. 2. In addition, the display housing unit 210 and the light source housing unit 220 may be fixed through a fixed frame.

Meanwhile, the display housing unit 210 may be disposed on the ceiling. Furthermore, the light source housing unit 220 may be installed in a form embedded into a wall connected to the ceiling. Therefore, the light source housing unit 220 connected in a right angle direction may not be exposed.

Meanwhile, referring to (b) of FIG. 2, at least part of the front surface of the display unit 151 may be exposed on an outside of the lower surface of the display housing unit 210. Furthermore, a window-shaped decoration 230 may be coupled to an outside of the lower surface of the exposed display housing unit 210. Accordingly, part of the front surface of the display unit 151 exposed in the display housing unit 210 may be covered by the window-shaped decoration 230. Accordingly, the reflected light of the reflective mirror 200 that is transmitted through the display unit 151 may be covered by the window-shaped decoration 230, thereby forming a shadow corresponding to the window-shaped decoration 230.

In addition, a light shield 250 may be disposed on at least part of side surfaces of the display housing unit 210 to prevent light from leaking out from an inside of the display housing unit 210 to an outside thereof or from entering the display housing unit 210 from an outside thereof. In this case, the light shield 250 may be disposed such that each side surface of the display housing unit 210 extends outward.

Meanwhile, FIG. 3 is a perspective view showing a structure of the display housing unit 210 and the light source housing unit 220 that constitute the artificial sky simulation apparatus 300.

Referring to FIG. 3, the artificial sky simulation apparatus 300 according to an embodiment of the present disclosure may be configured in a form in which the display housing unit 210 that receives the display unit 151 and the reflective mirror 200, and the light source housing unit 220 that receives the light source unit 131 are connected to each other through the contact surfaces 212, 222.

In this case, the light source housing unit 220 may be provided with the light source unit 131, as shown in a lower left of FIG. 3, and may include a drive unit 132 disposed to move the light source unit 131 in one direction. To this end, the drive unit 132 may include a rail and a mount disposed to be movable through the rail. Furthermore, the light source unit 131 disposed to face in a preset direction may be coupled and fixed to the mount. In addition, the mount may be provided with a moving mechanism including an actuator for moving the mount on the rail and at least one mechanical element such as a gear and a wheel under the control of the control unit 100.

Meanwhile, one surface of the housing of the light source housing unit 220 may be disposed to have an inclined surface 222 that forms a preset inclined angle (second acute angle) with one surface of the housing where the light source unit 131 is disposed. The inclined surface 222 may include a light passage groove 223 disposed to allow light from the light source unit 131 to pass therethrough. In addition, the inclined surface 222 of the light source housing unit 220 may be a contact surface through which the display housing unit 210 comes into contact with and is connected to the light source housing unit 220.

Meanwhile, the display housing unit 210 may include a lower surface 211 including a hole formed so as to allow the display unit 151 to be disposed, and an upper surface 213 on which a reflective mirror facing a rear surface of the display unit 151 is disposed, as shown in a lower right of FIG. 3. In addition, one surface 212 of the side surfaces of the display housing unit 210 may be an inclined surface so as to form a preset inclined angle (first acute angle) with respect to the upper surface 213. The inclined surface 212 may include a light passage groove 213 disposed to allow light from the light source unit 131 to pass therethrough, and may be a contact surface that comes into contact with and is connected to the light source housing unit 220.

Additionally, the first acute angle and the second acute angle may be complementary to each other. Accordingly, the display housing unit 210 and the light source housing unit 220 may be connected to each other such that the reflective mirror 200 provided in the display housing unit 210 and one surface of the light source housing unit 220 in which the drive unit 132 is disposed are perpendicular to each other.

Meanwhile, as shown in FIG. 4, a hole 215 may be formed on a lower surface of the display housing unit 210. Therefore, at least part of a front surface of the display unit 151 disposed on an inner side of the lower surface of the display housing unit 210 may be exposed to an outside of the lower surface of the display housing unit 210 through the hole 215.

In addition, the reflective mirror 200 disposed to face the display unit 151 may be disposed on an upper inner side of the display housing unit 210 facing a lower surface of the display housing unit 210. Therefore, the reflective mirror 200 may be disposed to face a rear surface of the display unit 151. In addition, the same light transmitting groove may be disposed in common on both sides of the contact surface 212 of the display housing unit 210 and the contact surface 222 of the light source housing unit 220. Furthermore, in the light source housing unit 220, the light source unit 131 disposed to irradiate light at a preset angle through the light transmitting groove may be disposed. Here, the preset angle may be an angle corresponding to a reflection angle of the reflective mirror 200 that allows light from the light source unit 131 to be irradiated to a rear surface of the display unit 151 through the reflective mirror 200.

Therefore, when light is emitted from the light source unit 131, the light from the light source unit 131 may be irradiated to the reflective mirror 200 through the light transmitting grooves disposed on both sides of the contact surface 212 of the display housing unit 210 and the contact surface 222 of the light source housing unit 220. Furthermore, light may be reflected from the reflective mirror 200. Then, the light from the light source unit 131 reflected from the reflective mirror 200 may be irradiated to the rear surface of the display unit 151 according to the reflection angle.

Meanwhile, the display unit 151 may be a transparent display apparatus such as TOLED. Therefore, the light reflected by the reflective mirror 200 may be transmitted through the display unit 151, and irradiated to an outside of the lower surface of the display housing unit 210.

In this case, the display unit 151 may output various sky images set by the user. Therefore, the sky image may be transmitted to the light of the light source unit 131. Accordingly, light radiated from an optical center of the light source unit 131 may be transmitted through the sky image, and irradiated to an indoor area where the artificial sky simulation apparatus 300 according to an embodiment of the present disclosure is disposed.

In this case, the light from the light source unit 131 may be irradiated onto the sky image (display unit 151) along the light path by the reflective mirror, and thus sunlight incident on the atmospheric layer may be simulated. Accordingly, an object in the sky image, such as a cloud, a bird, or a leaf from a tall tree, may cover the sunlight, thereby forming a shadow or the like. Accordingly, light more similar to sunlight may be simulated, and in this case, an optical center of the light source unit 131 may be simulated as the sun.

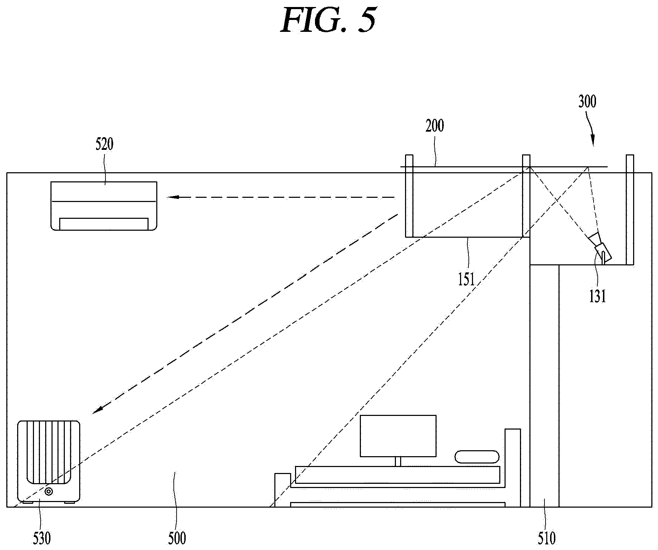

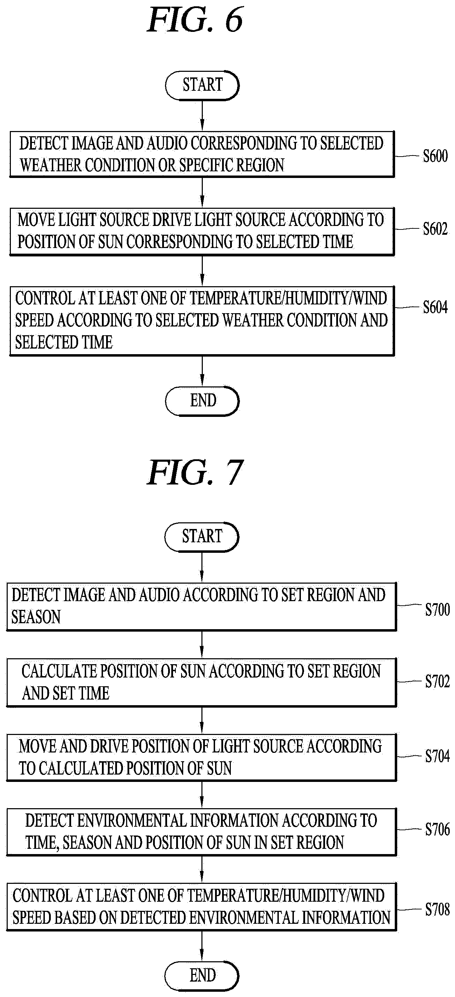

Meanwhile, according to an embodiment of the present disclosure, it has been mentioned that the artificial sky simulation apparatus 300 can simulate an atmospheric environment according to a sky image displayed through the display unit 151 by controlling at least one peripheral device. FIGS. 5 to 11 are drawings for explaining an operation and an example of simulating, based on a sky image selected by the user, an atmospheric environment corresponding to the selected sky image. In addition, in the following description, an operation process of FIGS. 6 to 9, which describes an operation of the artificial sky simulation apparatus 300 according to an embodiment of the present disclosure, may start when the artificial sky simulation apparatus 300 is turned on.

First, FIG. 5 is an exemplary view showing an example of controlling, by the artificial sky simulation apparatus 300 according to an embodiment of the present disclosure, at least one peripheral device.

Referring to FIG. 5, the artificial sky simulation apparatus 300 according to an embodiment of the present disclosure may be disposed in a form in which the display housing unit 210 is fixed to the ceiling of an indoor space using a plurality of anchor bolts as described above. In this case, the light source housing unit 220 may be disposed in a form that is embedded into a wall 510 connected to one side of the ceiling where the display housing unit 210 is disposed. Therefore, the light source housing unit 220 may not be exposed to the indoor space where the display housing unit 210 is disposed.

In this manner, when the artificial sky simulation apparatus 300 is disposed, as shown in FIG. 5, light 500 emitted from the light source unit 131 may be reflected by the reflective mirror 200 and irradiated to the rear surface of the display unit 151, and the light irradiated to the rear surface of the display unit 151 may be transmitted through the display unit 151 and irradiated into the indoor space. Accordingly, sunlight incident through a sky corresponding to a sky image displayed through the display unit 151 may be simulated.

Meanwhile, as shown in FIG. 5, the artificial sky simulation apparatus 300 may be connected to at least one air conditioner 520, and at least one air purifier or humidifier 530. Furthermore, the artificial sky simulation apparatus 300 may control the at least one air conditioner 520, air purifier or humidifier 530 based on the sky image displayed on the display unit 151.

FIG. 6 is a flowchart showing an operation process of simulating, by the artificial sky simulation apparatus 300 according to an embodiment of the present disclosure, the sky and atmospheric environment corresponding to a weather condition selected by a user.

Referring to FIG. 6, the control unit 100 of the artificial sky simulation apparatus 300 according to an embodiment of the present disclosure may detect a sky image corresponding to a weather condition or a specific region selected by the user. Furthermore, once the sky image is detected, an audio signal corresponding to the detected sky image may be detected. Furthermore, the detected audio signal may be output together with the selected sky image (S600).

In this case, the detected audio signals may vary depending on the sky image selected by the user. For example, the selected sky image is a sky image corresponding to "morning sky," an audio signal such as a chirping sound of a bird may be detected. Additionally, when the output sky image is a sky image corresponding to the "night sky," an audio signal that can be heard in the evening, such as the sound of crickets or grasshoppers, may be detected. In addition, the output sky image corresponds to an image corresponding to a "thunderstorm" with rainstorm or thunder or lightning, an audio signal such as the sound of rain and the sound of thunder may be detected.

Meanwhile, there may be a plurality of audio signals detected for a sky image. In this case, the control unit 100 may combine a plurality of audio signals to output as an audio signal corresponding to a specific sky image. For example, in the case of a sky image corresponding to the "night sky," an audio signal corresponding to the sound of crickets and an audio signal corresponding to the sound of grasshoppers may be combined to output an audio signal corresponding to the sky image of the "night sky." In this case, both the sound of crickets and the sound of grasshoppers may be output for the sky image of the "night sky."

Similarly, audio signals corresponding to specific sky images may be combined according to the user's selection. As an example, the user may arbitrarily combine a plurality of audio signals. Furthermore, the plurality of combined audio signals may be stored as an audio signal corresponding to a specific sky image. In this case, when the user selects the specific sky image, the plurality of audio signals selected according to the combination may be played sequentially or simultaneously. Here, the user may determine an output order of the combined audio signals or set a delay time between respective audio signals. In this case, an audio signal with a set delay time may be played repeatedly in cycles of the delay time.

Furthermore, the control unit 100 may calculate a position of the sun according to a point of time selected by the user, for example, a specific time or a specific period of time. Furthermore, the drive unit 132 may be controlled to move the light source unit 131 according to the calculated position of the sun (S602). For example, when the sun is at its highest point at noon, the control unit 100 may control the drive unit 132 to move the light source unit 131 to a position where a light source center of the light source unit 131 can be seen at the center of a front area of the exposed display unit 151. For example, the position of the light source unit 131 may be a center portion on the drive unit rail.

On the contrary, when the time selected by the user is morning or afternoon, the position of the light source unit 131 may be moved so as to allow the center of the light source of the light source unit 131 to be seen at a position biased to one side of the front area of the exposed display unit 151. In this case, the position of the light source unit 131 may be a front or rear portion of the drive unit rail. That is, by changing the position of the light source unit 131 on the driving rail, the control unit 100 of the artificial sky simulation apparatus 300 according to an embodiment of the present disclosure may simulate a change in the position of the sun over time.

In this case, the control unit 100 may simulate the movement of the sun according to a time elapsed since the artificial sky simulation apparatus 300 was turned on, even when the user does not select a specific time. That is, when three hours have elapsed since the artificial sky simulation apparatus 300 was turned on, the control unit 100 may move the position of the light source unit 131 on the drive unit rail by a length corresponding to a distance the sun moves for three hours. Therefore, by simulating the movement of the sun according to an actual warned time, a more realistic artificial sky may be output.

Meanwhile, the artificial sky simulation apparatus 300 according to an embodiment of the present disclosure may control an atmospheric environment in an indoor space where the artificial sky simulation apparatus 300 is installed based on a sky image selected in the step S600 and a position of the sun according to a time selected in the step S602 (S604). That is, the control unit 100 may identify at least one device among peripheral devices disposed in the indoor space that can affect the atmospheric environment, and control the identified device. Here, at least one device capable of affecting the atmospheric environment, which is a device capable of changing at least one of the temperature, humidity, or wind direction of the indoor space, may be at least one air conditioner 520, an air purifier, and a humidifier 530 disposed in the indoor space.

As an example, in the step S604, when the sky image selected by the user is "clear sky," the control unit 100 may control the air conditioner 520 to maintain an indoor air temperature at about 25 degrees. Furthermore, the air conditioner 520 or air purifier 530 may be controlled so as to form wind at a preset air volume. On the contrary, when the sky image selected by the user is a rainy weather condition such as "drizzle" or "thunderstorm," the air conditioner 520 may be controlled to maintain a lower indoor temperature (e.g. 20 degrees). Furthermore, the air purifier or humidifier 530 may be controlled to further increase the humidity of the indoor space. Therefore, a condition where the humidity increases as it rains may be simulated.

Meanwhile, in the step S604, the control unit 100 may control the peripheral device differently depending on the time selected by the user. For example, when the time selected by the user is a morning time (e.g., 6:00 a.m. to 11:00 a.m.), the control unit 100 may adjust the position of the light source unit 131 according to the selected time and simultaneously control the air purifier or humidifier 530 to increase the humidity of the indoor space. Therefore, a high humidity condition in the morning may be simulated. Additionally, the air conditioner 520 may be controlled to maintain the temperature of the indoor air at a lower temperature (e.g., 22 degrees). Therefore, a refreshing atmosphere due to the coolness and high humidity characteristic of the morning when the altitude of the sun is low may be simulated.

For example, when the time selected by the user is an afternoon time (e.g., 1:00 a.m. to 5:00 a.m.), the control unit 100 may adjust the position of the light source unit 131 according to the selected time and simultaneously control the air purifier or humidifier 530 to decrease the humidity of the indoor space. Furthermore, the air conditioner 520 may be controlled to further increase the temperature of the indoor air (e.g., 25 degrees). Therefore, an atmospheric environment where temperature rises and dries out as the altitude of the sun increases may be simulated.

Meanwhile, the humidity and temperature control may be linked to the position of the sun. That is, when a predetermined amount of time has elapsed while the user has selected a specific weather condition and a specific time, the control unit 100 may calculate a change in the altitude of the sun according to the passage of time, and change the position of the light source unit 131 according to the calculated altitude of the sun. Furthermore, at least one of the air conditioner 520 and the air purifier or humidifier 530 may be controlled so as to change the humidity and temperature according to the altitude of the sun.

In addition, the control unit 100 may control the air purifier or humidifier 530 to emit different scents depending on the selected sky image and the selected time when the air purifier or humidifier 530 is capable of emitting scent (e.g., an aroma humidifier). For example, when the user selects "morning sky," the control unit 100 may control the air purifier or humidifier 530 to emit cypress scent. On the contrary, when the user selects "clear sky," the control unit 100 may control the air purifier or humidifier 530 to emit an autumn flower scent, such as cosmos scent.

Meanwhile, the control unit 100 of the artificial sky simulation apparatus 300 according to an embodiment of the present disclosure may select a sky image according to a specific region selected by the user. For example, the control unit 100 may select a region corresponding to various environments such as a "polar region," a "beach," and a "recreational forest" from the user. Furthermore, when such a specific region is selected, the sky image, audio signal, and scent corresponding to the selected region may be determined.

FIG. 7 is a flowchart showing an operation process of simulating, by the artificial sky simulation apparatus 300 according to an embodiment of the present disclosure, the sky and atmospheric environment according to a region, a season, and a time selected by the user.

Referring to FIG. 7, the artificial sky simulation apparatus 300 according to an embodiment of the present disclosure may detect a sky image according to a specific region and a specific season (or a specific date) set by the user. Furthermore, at least one audio signal corresponding to the detected sky image may be detected (S700). Here, the at least one audio signal may be a plurality of audio signals combined according to the user's selection.

Here, the specific region may be a region having different natural environments. Examples include a polar region, a desert, an island, a beach, a tundra area, in woods, and a recreational forest. That is, the control unit 100 may display a plurality of regions that can be selected by the user, each divided into different natural environments, and when the user selects a region corresponding to any one natural environment, the control unit 100 may detect a sky image corresponding to the selected region. Furthermore, an audio signal corresponding to the detected sky image may be detected.

Therefore, when the user selects a polar region or a tundra area, an image of the sky viewed from the polar region or tundra area may be detected as the sky image selected by the user. In this case, the detected sky image may be an image including aurora, or the like. Then, the control unit 100 may detect an audio signal corresponding to the aurora.

Alternatively, when the user selects an island or beach, an image of the sky seen from the island or beach may be detected as the selected sky image. In this case, the detected sky image may include exotic scenery such as palm trees. Furthermore, the control unit 100 may detect an audio signal such as a sound of waves.

Then, the control unit 100 may calculate the altitude of the sun corresponding to a specific time selected by the user in a selected region selected by the user (S702). Furthermore, depending on the calculated altitude of the sun, the control unit 100 may control the drive unit 132 to change the position of the light source unit 131.

For example, near the coast or beach, the altitude of the sun may be higher. However, in a polar region, the altitude of the sun may be low even at noon. Therefore, even when the same time is set, the altitude of the sun may be different, and accordingly, the position of the light source unit 131 to simulate the position of the sun may be different. That is, different altitudes of the sun for each region may be simulated through different positions of the light source unit 131.

Meanwhile, when the position of the sun is simulated, the control unit 100 may detect environmental information according to the position of the sun calculated according to a currently set region, set time, and set season (S706). Furthermore, at least one peripheral device (e.g., air conditioner 520, air purifier, or humidifier 530) disposed in an indoor space may be controlled so as to allow at least one of temperature, humidity, and wind direction of the indoor space to vary according to the detected environmental information (S708).

In this case, the base temperature and the base humidity may be determined according to the currently set region and season. In this state, the base temperature and the base humidity may be changed depending on the position of the sun corresponding to the time selected by the user.

For example, when the user selects a morning time, the control unit 100 may lower the base temperature based on a difference between the time selected by the user and the base time (e.g., noon time) corresponding to the base temperature and the base humidity. Furthermore, it may increase the base humidity. Accordingly, the control unit 100 may control the air conditioner 520 and air purifier or humidifier 530 such that the earlier in the morning the time selected by the user, the lower the temperature and higher the humidity.

On the contrary, when the user selects a morning time, the control unit 100 may raise the base temperature and lower the base humidity based on a difference between the time selected by the user and the base time (e.g., noon time) corresponding to the base temperature and the base humidity. Therefore, the later in the afternoon the user selects the higher the temperature and lower the humidity may be.

Meanwhile, when the time selected by the user is an evening time or night time, the control unit 100 may generate a sky image corresponding to the evening time or night time by varying the color temperature of the light source unit 131. For example, when the region selected by the user emits light having a color temperature of 5000K, which has a bright color tone during the day, light having a color temperature of 3000K, which has a warm color tone, may be emitted during the evening. In addition, the light source unit 131 may be controlled to emit light having a color temperature of 8000K with a cool color tone so as to simulate the night sky and the moon and moonlight floating in the night sky. In this case, the control unit 100 may simulate a position of the moon in a similar manner as the position of the sun, and may also move the position of the light source unit 131 according to the simulated position of the moon. In this case, when the night sky is simulated, the control unit 100 may control the air conditioner 520 and air purifier or humidifier 530 so as to lower the temperature and raise the humidity compared to the morning time.

The color temperature may be applied not only in the evening time or at the night time, but also when simulating the sun in the morning time. As an example, when the time selected by the user is a morning time, the control unit 100 may control the light source unit 131 to emit light having a color temperature of 2000K with a warm color tone.

Meanwhile, when the air purifier and humidifier 530 are capable of emitting a plurality of different scents, the control unit 100 may control the air purifier and humidifier 530 to output different scents depending on a region corresponding to the sky image selected by the user. As an example, when the region selected by the user is an island or beach, the control unit 100 may control the air purifier or humidifier 530 to emit a sea scent. On the contrary, when the region selected by the user is in woods or a resort forest, the control unit 100 may control the air purifier or humidifier 530 to emit cypress scent.

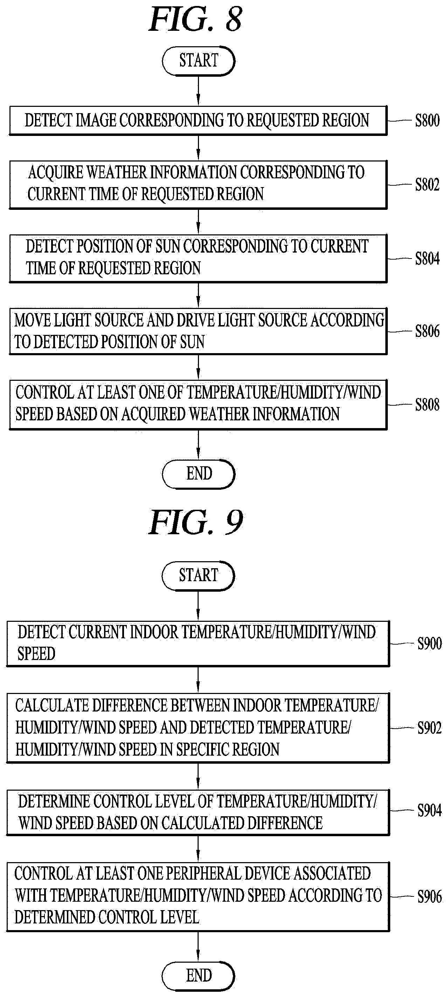

Meanwhile, the artificial sky simulation apparatus 300 according to an embodiment of the present disclosure may simulate an artificial sky according to a current time, season, and weather condition of a specific region according to the user's selection. FIG. 8 is a flowchart showing an operation process of simulating, by the artificial sky simulation apparatus 300 according to an embodiment of the present disclosure, the sky and atmospheric environment according to a current weather condition and a time in a specific region at the user's request.

Referring to FIG. 8, when the user selects a specific region, the control unit 100 may detect a sky image corresponding to the selected region (S800). Here, the specific region may be a major urban region, such as a historic site or the capital of a well-known country. In this case, the specific region may include an image of a landmark of the region.

For example, the user may select "London." In this case, the control unit 100 may detect a sky image of London that includes at least part of the London Eye or at least part of Big Ben. Alternatively, when the user selects "Paris," the control unit 100 may detect a sky image of Paris that includes at least part of the Eiffel Tower or the Arc de Triomphe. Alternatively, when the user selects "Cairo," it may detect an image of the sky over Egypt that includes at least part of the pyramids or the Sphinx.

Then, the control unit 100 may acquire a current time of the requested region and weather information of the requested region (S802). As an example, the control unit 100 may be connected to a preset server that provides a current time and current weather information for each region through the communication unit 110, and may acquire time and weather information for the requested region from the connected server.

Then, the control unit 100 may detect the position of the sun corresponding to the time of the requested region (S804). To this end, the control unit 100 may refer to the latitude of the requested region, and calculate a position of the sun (e.g., the altitude of the sun) by considering the latitude of the requested region. Furthermore, depending on the calculated position of the sun, the light source unit 131 may be moved, and the color temperature of the light source unit 131 may be changed depending on the time of the requested region (S806).

Furthermore, the control unit 100 may vary the atmospheric environment of the indoor space based on the weather information acquired in the step S802 (S808). For example, when the region selected by the user is "London," and the current weather condition in "London" is rainy, and the time is a morning time, the control unit 100 may output an image of rainy sky in "London" on the display unit 151 according to the detected rainy weather with the image of "London" as a background. Furthermore, the position of the light source unit 131 may be determined based on a position of the sun in the morning in "London," and the light source unit 131 may be moved to the determined position. Furthermore, at least one of the air conditioner 520 and air purifier or humidifier 530 disposed in the indoor space may be controlled to form a temperature, humidity, and wind speed corresponding to a current temperature, humidity, and wind speed of the detected "London" (S808). Accordingly, an artificial sky according to a current weather condition and current time of a specific region selected by the user may be simulated, and an atmospheric environment according to a current weather condition and current time of the selected specific region may be simulated.

Meanwhile, since the air conditioner 520 and air purifier or humidifier 530 have a limited change range of temperature or humidity, there may be limitations in simulating an atmospheric environment of a specific region selected by the user as described in FIG. 8 through the air conditioner 520 and the air purifier or humidifier 530. Accordingly, the control unit 100 may allow the user to feel an atmospheric environment according to a specific region selected by the user depending on a difference in the atmospheric environment.

FIG. 9 is a flowchart showing an operation process of adjusting, by the artificial sky simulation apparatus 300 according to an embodiment of the present disclosure, an atmospheric environment around the user according to an indoor atmospheric condition and an atmospheric environment to be simulated.

Referring to FIG. 9, the control unit 100 of the artificial sky simulation apparatus 300 may first detect at least one of a current temperature, humidity, and wind speed of the room prior to controlling the air conditioner 520 and air purifier or humidifier 530 according to an atmospheric environment of a specific region selected by the user (S900). Furthermore, at least one of the detected temperature, humidity and wind speed may be compared with at least one of the temperature, humidity and wind speed acquired from the current weather condition of the specific region selected by the user. Furthermore, the difference may be calculated (S902).

Furthermore, the control unit 100 may determine a control level to control at least one of temperature, humidity, and wind speed based on the calculated difference (S904). Here, the control level may be determined in proportion to the calculated difference in the step S902. That is, the larger the detected difference, the larger the control level may be determined, and the smaller the difference, the smaller the control level may be determined.

For example, when the temperature of the indoor space where the artificial sky simulation apparatus 300 is disposed is 20 degrees, the set temperature of a specific region may be 11 degrees. In this case, the control unit 100 may determine the control level as 3 degrees, which is 1/3 of the calculated difference (9 degrees). That is, the control unit 100 may determine a control level in a form that reduces the calculated difference by a predetermined ratio (reduction ratio). In this case, the reduction ratio may be determined differently depending on temperature, humidity, or wind speed.

When the control level is determined in the step S904, the control unit 100 may control at least one related peripheral device, that is, at least one air conditioner 520 and air purifier or humidifier 530, so as to change at least one of the temperature, humidity, and wind speed of the indoor space according to the determined control level (S906). Therefore, a variation range of temperature, humidity and wind speed in the indoor space may differ depending on a difference between a current weather condition in a region selected by the user and a temperature humidity and wind speed of the indoor space where the user is positioned. Meanwhile, since the temperature, humidity, and wind speed of the indoor space change rapidly under the control of the step S906, in terms of feeling, the user may feel a change in temperature, humidity, and wind speed to be greater than its actual amount of change. Therefore, in terms of feeling, the user may more realistically feel the simulated artificial sky.

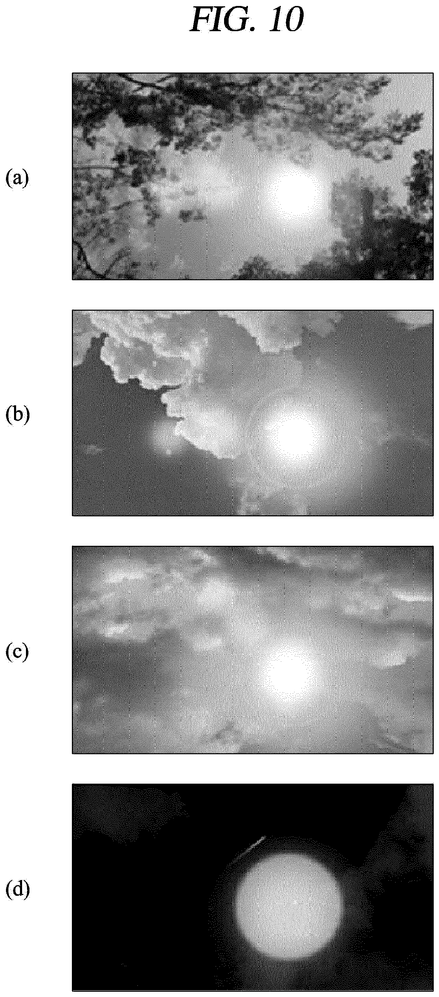

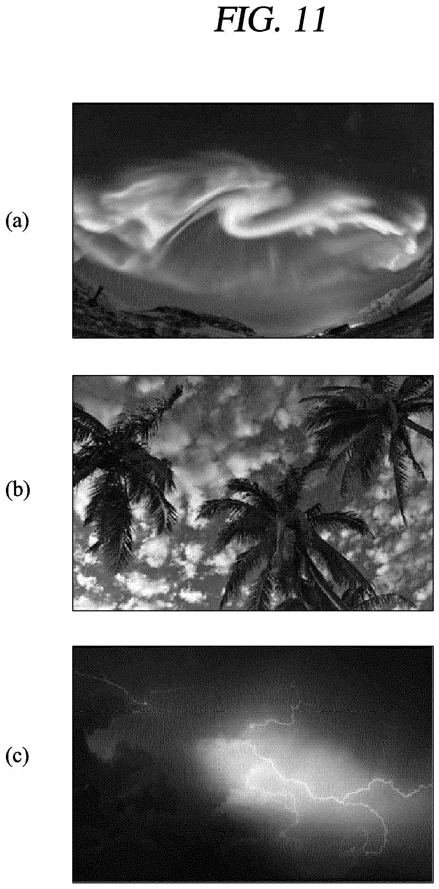

Meanwhile, FIG. 10 shows examples of artificial skies corresponding to different times that can be simulated by the artificial sky simulation apparatus 300 according to an embodiment of the present disclosure. In addition, FIG. 11 shows examples of artificial skies corresponding to different regions and different weather conditions that can be simulated by the artificial sky simulation apparatus 300 according to an embodiment of the present disclosure.

First, referring to FIG. 10, (a) of FIG. 10 shows an example of a sky image corresponding to a morning sky, that is, when the time selected by the user is morning. The sky image may include an image of flowing morning fog. In addition, the control unit 100 of the artificial sky simulation apparatus 300 may control the light source unit 131 to emit light having a color temperature of warm color (2000K), and may limit a brightness of a light source to about 30%. This simulates a brightness of the sun due to a solar altitude at the morning time.

Additionally, the control unit 100 may output an audio signal corresponding to a chirping sound of a bird in response to the sky image of the morning sky. Furthermore, when a base temperature (noon temperature) is 25 degrees, a peripheral device (e.g. air conditioners) may be controlled to maintain a temperature (e.g. 22 degrees) lower than the base temperature, and the peripheral device may be controlled to blow wind at a low speed. Additionally, if possible, a peripheral device (e.g., aroma humidifier) may be controlled to emit a scent (e.g., cypress scent) corresponding to the sky image of the morning sky.

Meanwhile, (b) of FIG. 10 shows an example of a sky image corresponding to a clear sky in the afternoon, that is, when the time selected by the user is afternoon. In this case, the sky image may include an image of blue sky and passing clouds. In addition, the control unit 100 of the artificial sky simulation apparatus 300 may control the light source unit 131 to emit light having a color temperature of bright color (5000K), and may increase a brightness of a light source to about 70%. This simulates a brightness of the sun due to a higher solar altitude at the afternoon time.

Additionally, the control unit 100 may output audio signals corresponding to a sound of a wind and a sound of a bamboo forest in response to an image of clear sky in the afternoon. Furthermore, a peripheral device may be controlled to maintain the base temperature (noon temperature), and the peripheral device may be controlled to blow wind at a high speed. When simulating a case where the temperature increases like this, the air conditioner may operate in a fan function rather than a cooling function.

(c) of FIG. 10 shows an example of a sky image corresponding to the sunset sky, when the time selected by the user is evening. In this case, the sunset sky image may include an image of red clouds passing by corresponding to the sunset. In addition, the control unit 100 of the artificial sky simulation apparatus 300 may control the light source unit 131 to emit light having a color temperature of warm color (3000K), and may lower a brightness of a light source to about 30%. This simulates a brightness of the sun due to a lower solar altitude in the evening.

Additionally, the control unit 100 may output audio signals corresponding to the sound of seagulls or waves in response to the sunset sky image. Furthermore, a peripheral device may be controlled to maintain the base temperature (noon temperature), and the peripheral device may be controlled to blow wind at a low speed.

(d) of FIG. 10 shows an example of a sky image corresponding to the night sky, that is, when the time selected by the user is night. In this case, the night sky image may include an image of a shooting star passing through a dark sky. In addition, the control unit 100 of the artificial sky simulation apparatus 300 may control the light source unit 131 to emit light having a color temperature of cool color (8000K), and may lower a brightness of a light source to about 5%. This is to simulate the moon floating in the night sky.

Additionally, the control unit 100 may output audio signals corresponding to the sound of crickets or the sound of grasshoppers in response to the night sky image. Furthermore, a peripheral device may be controlled to maintain a temperature (e.g. 22 degrees) lower than the base temperature (noon temperature), and the peripheral device may be controlled to blow wind at a low speed.

Furthermore, FIG. 11 is an exemplary view for explaining an example of simulating, by the artificial sky simulation apparatus 300 according to an embodiment of the present disclosure, the sky and atmospheric environments corresponding to different weather conditions and different regions.

Referring to (a) of FIG. 11, (a) of FIG. 11 shows an example of a sky image displayed when the user selects a polar region. In this case, the artificial sky simulation apparatus 300 according to an embodiment of the present disclosure may detect a sky image (aurora sky image) including an aurora as shown in (a) of FIG. 11, and may detect an audio signal corresponding to the aurora sky image. Furthermore, it may output the detected aurora sky image and audio signal. Furthermore, the control unit 100 may control a peripheral device to change at least one of the temperature, humidity and wind speed of the indoor space according to the time selected by the user, and the base temperature, humidity and wind speed corresponding to the selected region (polar region).

Meanwhile, referring to (b) of FIG. 11, (b) of FIG. 11 shows an example of a sky image displayed when the user selects a beach region. In this case, the artificial sky simulation apparatus 300 according to an embodiment of the present disclosure may output a sky image (beach sky image) including objects such as palm trees such that it may be shown that it is a beach region, as shown in (b) of FIG. 11. Furthermore, it may be possible to output an audio signal corresponding to the beach sky image. In this case, the output audio signal may be a sound of waves, or the like. Furthermore, the control unit 100 may control a peripheral device to change at least one of the temperature, humidity, and wind speed of the indoor space according to the time selected by the user, and the base temperature, humidity, and wind speed corresponding to the selected region (beach region).

Meanwhile, (c) of FIG. 11 shows an example of a sky image in which a thunderstorm has occurred, when the weather condition selected by the user is a thunderstorm weather condition. The thunderstorm sky image may include an image of clouds and lightning in a dark sky. In addition, the control unit 100 of the artificial sky simulation apparatus 300 may control the light source unit 131 to emit light having a color temperature of 10,000K based on a few seconds, and may increase a brightness of a light source by 100%. In this case, since the light source unit 131 emits light at 100% brightness based on the few seconds, an effect similar to lightning striking between the dark cloud objects may be created.

Additionally, the control unit 100 may output an audio signal corresponding to a sound of rain and thunder in response to the sky image of the thunderstorm sky. Furthermore, it may be possible to control a peripheral device (e.g., air conditioner) to maintain a temperature (e.g., 22 degrees) lower than the base temperature, and control the peripheral device to blow wind at a high speed. A peripheral device may be controlled to generate a humidity higher than the base humidity.

Meanwhile, in the foregoing description, a structure of the artificial sky simulation apparatus 300 in which the display housing unit 210 and the light source housing unit 220 are coupled along contact surfaces having an inclination according to first and second complementary angles forming complementary angles, and are connected to each other at a right angle has been described. However, a size of the light source housing unit 220 may of course be further reduced by using an upper surface of the display housing unit 210. In this case, the display housing unit 210 and the light source housing unit 220 may have a different shape from that shown in FIG. 2. In order to distinguish the artificial sky simulation apparatus 300 according to an embodiment of the present disclosure having a different form from that shown above in FIG. 2 from the artificial sky simulation apparatus 300 described below, the artificial sky simulation apparatus 300 according to the form shown above in FIG. 2 will be referred to as the artificial sky simulation apparatus 300 according to a first embodiment of the present disclosure, and the artificial sky simulation apparatus 1200 having a modified structure described below will be referred to as the artificial sky simulation apparatus 300 according to a second embodiment of the present disclosure.

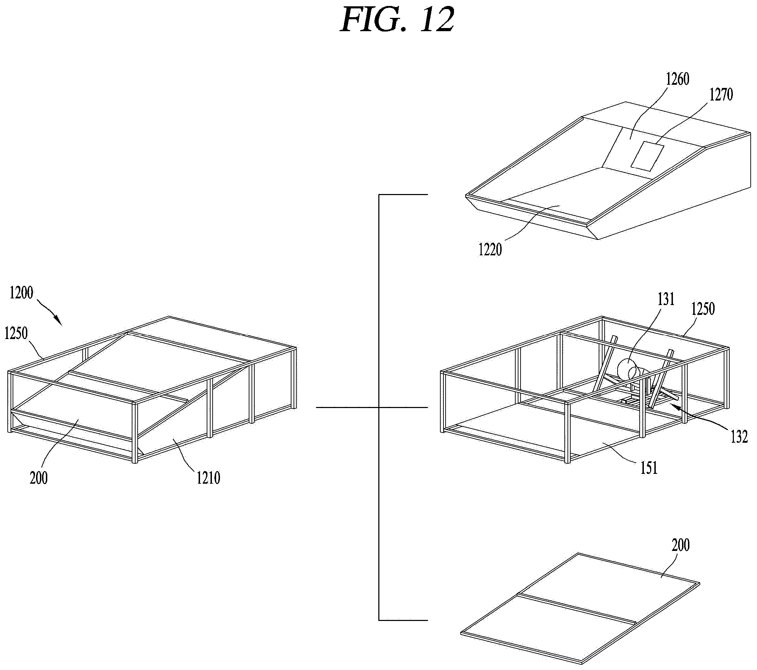

FIG. 12 is an assembly view showing a second embodiment in which the display housing unit 210 and the light source housing unit 220 of the artificial sky simulation apparatus 1200 according to an embodiment of the present disclosure have different shapes, and a structure of the artificial sky simulation apparatus 1200 according to the second embodiment.

Referring to FIG. 12, the artificial sky simulation apparatus 1200 according to a second embodiment of the present disclosure may be disposed such that an upper surface of the display housing unit 210 in which the reflective mirror 200 is disposed is inclined inward at a predetermined angle, as shown in a left drawing of FIG. 12. Accordingly, the reflective mirror 200 disposed on an upper surface of the display housing unit 210 may also be disposed at a predetermined angle with respect to a rear surface of the display unit 151.

Meanwhile, as the reflective mirror 200 is disposed at an angle as described above, the position of the light source unit 131 disposed to face the reflective mirror 200 may vary depending on a preset reflection angle. That is, due to an inclination of the reflective mirror 200, the position of the light source unit 131 may be higher than that of the artificial sky simulation apparatus 1200 according to the first embodiment. Therefore, when the inclination of the reflective mirror 200 is sufficient, the light source unit 131 may be disposed at a height that is horizontal to the display unit 151, as shown in the drawing on a right middle of FIG. 2.

As the light source unit 131 is disposed at a height that is horizontal to the display unit 151, a lower surface of the light source housing unit 220 may not protrude more than a lower surface of the display housing unit 210. Accordingly, as shown in FIG. 12, the lower surface of the light source housing unit 220 may be disposed along an extension line of the lower surface of the display housing unit 210, and in this case, the light source housing unit 220 may be coupled to the display housing unit 210 in a form extending from the display housing unit 210. In this case, the display housing unit 210 and the light source housing unit 220 may be integrally disposed as shown in the drawing on an upper right side of FIG. 12. Hereinafter, the integral housing will be referred to as a housing unit 1210.

In this case, the housing unit 1210 may have a boundary surface 1260 between an area in which the display unit 151 is received and an area in which the light source unit 131 is received. A light passage groove 1270 may be disposed on the boundary surface 1260 so as to allow light from the light source unit 131 to pass therethrough. Additionally, the boundary surface 1260 may be disposed with an inclined surface so as to be perpendicular to a direction facing the light source unit 131. Furthermore, based on the boundary surface 1260, a hole 1220 may be disposed on a lower surface of the display unit receiving area of the housing unit 1210 in which the display unit 151 is received. Accordingly, a front surface of the display unit 151 disposed inside the housing unit 1210 may be exposed through the hole 1220.

Meanwhile, an upper surface of the display unit receiving area of the housing unit 1210 may be disposed to be inclined inward at a predetermined angle as shown in an upper right drawing of FIG. 12. In this case, as shown above in a lower right drawing of FIG. 12, the reflective mirror 200 may also be disposed to be inclined along an upper surface of the inclined display unit receiving area.

Meanwhile, the housing unit 1210 may be fixed through a fixed frame 1250 as shown in a right middle drawing of FIG. 12. In this case, the fixed frame 1250 may be disposed to support the display unit 151 disposed inside the housing unit 1210, and may be disposed to include a rail disposed to allow the light source unit 131 to move to the same height as that at which the display unit 151 is disposed.

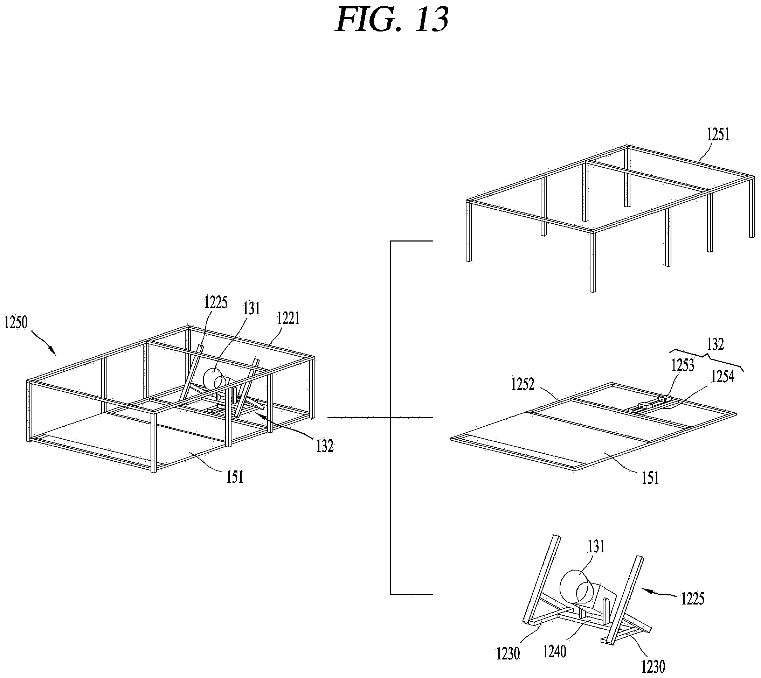

Furthermore, FIG. 13 is an assembly view showing a structure of a fixed frame 1250 including a light source unit 131 and a drive unit 132 disposed to move the light source unit 131 in the artificial sky simulation apparatus 1200 according to the second embodiment.

First, as shown on a left side of FIG. 13, the artificial sky simulation apparatus 1200 according to the second embodiment may be provided with the fixed frame 1250 in which the light source unit 131 and the drive unit 132 are disposed. Furthermore, the fixed frame 1250 may include an upper frame 1251 and a lower frame 1252 as shown in an upper right drawing and a middle drawing of FIG. 13.

First, the upper frame 1251 shown above in the upper right drawing of FIG. 13 may support a shape of the housing unit 1210, and provide a space in which the display unit 151, the reflective mirror 200, and the light source portion 131 are disposed, and an internal space for forming a reflection angle at which the light from the light source portion 131 is reflected by the reflective mirror 200 and irradiated to the display unit 151. Furthermore, the lower frame 1252 shown in a lower right drawing of FIG. 13 may be disposed to be coupled to the upper frame 1251, and internal frames disposed to support the display unit 151 may be disposed in the display unit receiving area. In addition, a rail 1254 that can move the light source unit 131 from a direction approaching the display unit 151 to a direction away from the display unit 151 may be disposed, and a mount 1253 disposed to mount and fix the light source unit 131 and to move the mounted light source unit 131 along the rail 1254 may be disposed in the light source unit receiving area.

Meanwhile, as shown in the lower right drawing of FIG. 13, the fixed frame 1250 may include a light source frame 1225 that supports the movement of the light source unit 131. Furthermore, the light source frame 1225 may be provided with two guide frames 1230 disposed to extend along a direction of movement of the light source unit 131, that is, a direction in which the rail 1254 is disposed, and a mount frame 1240 disposed to move along a direction in which the guide frame 1230 extends between the guide frames 1230. To this end, the guide frames 1230 may have coupling grooves disposed on an inside to which the mount frame 1240 is coupled, and the mount frame 1240 may be fastened to the coupling grooves of the guide frames 1230 to move along the coupling grooves.

Here, the mount frame 1240 is coupled to the light source unit 131, and the mount frame 1240 may be mounted and fixed to the mount 1253 shown in the right middle drawing of FIG. 13. Accordingly, when the mount 1253 moves along the rail 1254, the mount frame 1240 coupled to the mount 1253 may move along the guide frames 1230, and the light source unit 131 may move along a direction in which the rail 1254 is disposed according to the movement of the mount frame 1240.

In this case, the movement of the light source unit 131 may be performed along the mount frame 1240 guided by the guide frames 1230. Accordingly, as shown in a lower right of FIG. 13, the light source unit 131 may be fixed to move in only one direction by the guide frames 1230, and thus vibration of the light source unit 131 may be minimized when the light source unit 131 moves.

Meanwhile, when the light source unit 131 is moved in a direction closer to the display unit 151 or moved in a direction away from the display unit 151, an amount of light reflected by the reflective mirror 200 may vary. In this case, the brightness may also vary depending on a difference in the amount of light.

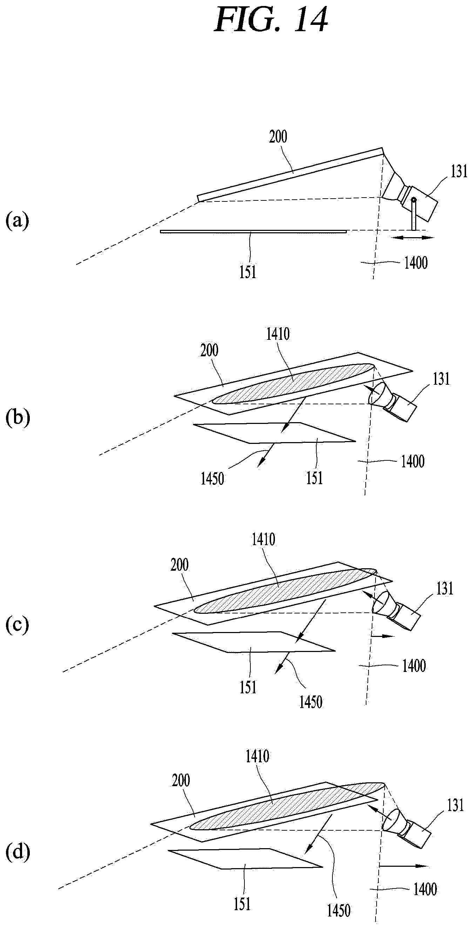

FIG. 14 is an exemplary view showing a change in brightness of transmitted light and amount of transmitted light transmitted through the display unit 151, that is, TOLED, according to the movement of the light source unit 131 in the artificial sky simulation apparatus 1200 according to the second embodiment as described above.

First, as described above, the artificial sky simulation apparatus 1200 according to an embodiment of the present disclosure may simulate the position of the sun that has moved over time by moving the position of the light source unit 131. (a) of FIG. 14 is an exemplary view showing an example in which the light source unit 131 is disposed to be movable in one direction according to the artificial sky simulation apparatus 1200, and light 1400 irradiated from the light source unit 131 is reflected by the reflective mirror 200 disposed inside an upper surface of the display unit receiving area of the housing unit 1210 disposed to be inclined and irradiated to a rear surface of the display unit 151.

In this case, the display unit 151 may be a transparent display apparatus that allows a predetermined level of light irradiated from a rear surface thereof to transmit therethrough. More preferably, the display unit 151 may be a display apparatus implemented with TOLED.

Accordingly, the reflected light of the reflective mirror 200 irradiated on a rear surface of the display unit 151 may be transmitted through the display unit 151 and irradiated on a front surface of the display unit 151. Therefore, the reflected image of an optical center of the light source unit 131 reflected by the reflective mirror 200 may be simulated as the sun while transmitting through the display unit 151. Accordingly, as a rear surface area of the display unit 151 on which the reflected image can be reflected becomes longer in accordance with a movement direction of the light source unit 131, a movement distance of the sun that can be simulated may become longer. Therefore, the light source unit 131 may be disposed to be movable in a longitudinal direction of the display unit 151 so as to simulate a longer movement distance of the sun.

Accordingly, the rail 1254 capable of moving the light source unit 131 in a longitudinal direction of the display unit 151 may be provided in the light source unit receiving area of the lower frame 1252. Furthermore, as the light source unit 131 moves along the rail 1254, the light source unit 131 may move along the longitudinal direction of the display unit 151.

Meanwhile, (b) to (c) of FIG. 14 show a reflected image formed on the reflective mirror 200 according to the movement of the light source unit 131 and a change in light transmitted through the display unit 151 according to the reflected image.

First, referring to (b) of FIG. 14, (b) of FIG. 14 shows an example in which a reflected image 1410 by light from the light source unit 131 is formed at the center of the reflective mirror 200. In this case, as shown in (b) of FIG. 14, all light irradiated from the light source unit 131 may be reflected from the reflective mirror 200. Accordingly, an amount of light irradiated to a rear surface of the display unit 151 may be maximum, and the brightness may also be maximum.

In this case, a reflected image corresponding to an optical center 1450 of light emitted from the light source unit 131 may be projected onto a rear surface of the display unit 151, and accordingly, the optical center 1450 may be illuminated like the sun on a front surface of the display unit 151. In this case, the sun may be at its highest altitude (e.g. in the sky at noon).

In this state, when the light source unit 131 moves along a longitudinal direction of the display unit 151 so as to move away from the display unit 151, as shown in (c) of FIG. 14, part of light from the light source unit 131 may be irradiated to an area outside the reflective mirror 200. In this case, total reflection of light does not occur in an area outside the reflective mirror 200, the amount and brightness of light reflected from the reflective mirror 200 may be reduced.

In addition, as the light source unit 131 moves, the position where the reflected image corresponding to the optical center 1450 of the light emitted from the light source unit 131 is projected onto a rear surface of the display unit 151 may also move along a longitudinal direction of the display unit 151. Therefore, a phenomenon of the altitude of the sun decreases as the sun moves may be simulated, and the amount and brightness of sunlight that decrease as the altitude of the sun decreases (e.g., afternoon sky) may be simulated.

Meanwhile, (d) of FIG. 14 shows an example in which the light source unit 131 is moved further along a longitudinal direction of the display unit 151 so as to be further away from the display unit 151. In this case, light from the light source unit 131 irradiated to an area outside the reflective mirror 200 may increase. Therefore, the amount and brightness of light reflected from the reflective mirror 200 may be further reduced.

In addition, as shown in (d) of FIG. 14, when the light source unit 131 moves, the position where the reflected image corresponding to the optical center 1450 of the light emitted from the light source unit 131 is projected may also be outside a rear surface area of the display unit 151. In this case, when the position where the reflected image corresponding to the optical center 1450 is projected is outside the rear surface area of the display unit 151, the reflected image corresponding to the optical center 1450 may not be projected onto a front surface of the display unit 151. Here, since the reflected image corresponding to the optical center 1450 simulates the sun, the sun may not be displayed on a front surface of the display unit 151 (e.g., sunset sky).

Meanwhile, the artificial sky simulation apparatus according to an embodiment of the present disclosure uses a transparent display apparatus as described above. Therefore, when the power is turned off, a shape inside the device may be exposed through the display unit 151. In addition, since the reflective mirror 200 is disposed to face a rear surface of the display unit 151, there is a problem in that not only the display unit receiving space but also an inside of the light source unit receiving space can be reflected through the reflective mirror 200.

In order to minimize a shape inside the device from being exposed through the transparent display apparatus, the artificial sky simulation apparatus 1200 according to an embodiment of the present disclosure may be disposed so as to allow that the inside of the device to be completely surrounded by a blackout layer. As an example, an inside of the device of the artificial sky simulation apparatus 1200 according to an embodiment of the present disclosure may be coated with a blackout layer to prevent light from being reflected. In this case, since an illumination inside the device is reduced due to the blackout layer, a shape inside the device may be prevented from being exposed through the transparent display apparatus.

However, there is a problem in that it is difficult to completely prevent the shape inside the device from being exposed through the transparent display apparatus with the blackout layer treatment or blackout layer coating. As an example, when strong light is irradiated from a front surface of the display unit 151, the shape inside the device may be exposed as it is.

Therefore, a method for preventing the shape inside the device from being exposed may be considered. As part of the method, liquid crystals may be used that are formed to transmit light depending on whether power is supplied.

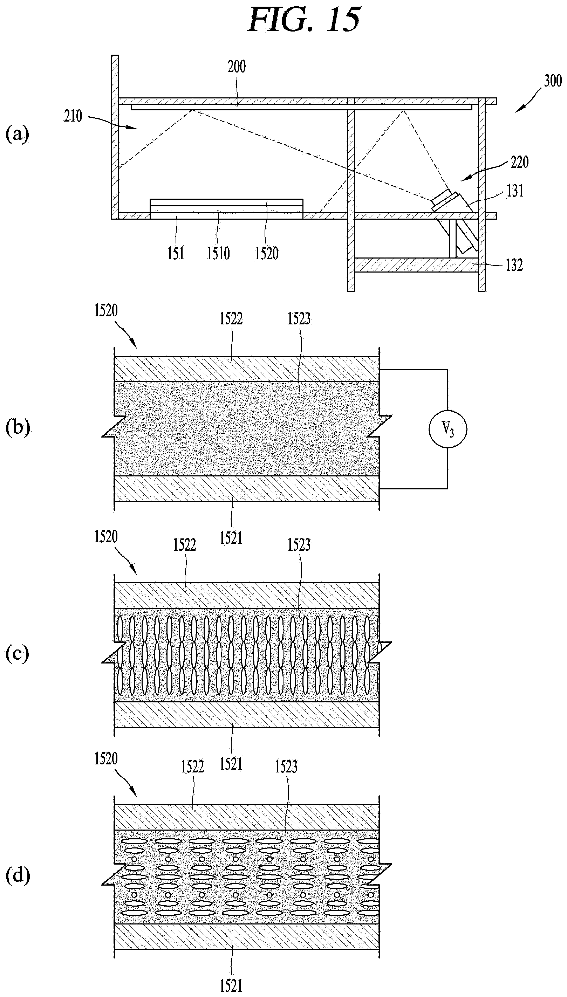

FIG. 15 is an exemplary view showing an example of a liquid crystal formed to transmit light depending on whether power is supplied between TOLED and a reflective mirror in an artificial sky simulation apparatus according to an embodiment of the present disclosure. In the following description, for convenience of explanation, it is assumed that an artificial sky simulation apparatus in which liquid crystals are disposed is according to a first embodiment of the present disclosure. However, the artificial sky simulation apparatus 1200 according to a second embodiment of the present disclosure may of course also have a structure in which liquid crystals are disposed as shown above in FIG. 15.

First, referring to (a) of FIG. 15, when the display unit 151 is TOLED, the TOLED may be provided with a polarizing filter 1510 disposed to transmit only polarized light in a first direction so as to improve a phenomenon of transmitted light spreading in a cross shape and to ensure that the light of the transmitted light source has homogeneity. In this case, the polarizing filter 1510 may be disposed between the display unit 151, that is, the TOLED 151, and the reflective mirror 200, to be laminated on the TOLED 151. Furthermore, a liquid crystal layer 1520 may be disposed between the polarizing filter 1510 and the reflective mirror 200, and may be laminated on the polarizing filter 1510.

Meanwhile, the liquid crystal layer 1520 may include an electric field-dependent layer 1523 disposed between a first electrode 1521 and a second electrode 1522 to which a specific voltage V3 is applied as shown in (b) of FIG. 15. Here, the electric field-dependent layer 1523 may be formed by charging an electric field dependent material.

Here, the electric field-dependent material may be at least one selected from a group including a liquid crystal material, a fluorescent material, a photonic crystal material, an electrophoresis material, and an electrowetting material, as a material whose properties change by an electric field disposed between the first electrode 1521 and the second electrode 1522. In the following description, any of the electric field-dependent materials may be used. However, for convenience of explanation, in the following description, among the liquid crystal materials that can achieve excellent light transmittance, a cholesteric liquid crystal material in which each layer of molecules arranged in a plane rotates in a spiral shape will be used as an example.

Meanwhile, (c) of FIG. 15 shows a liquid crystal arrangement in which the electric field-dependent material charged in the electric field-dependent layer 1523 of the cholesteric liquid crystal layer 1520 is in a homeotropic state. A liquid crystal in a homeotropic state denotes that a helical structure is untwisted and the liquid crystal molecules are aligned in a direction of electric field. The arrangement of those liquid crystal molecules in a homeotropic state is an arrangement when a high electric field is formed between the first electrode 1521 and the second electrode 1522, and has the characteristic of transmitting light. Accordingly, as shown in (b) of FIG. 15, incident light may be transmitted as it is, and accordingly, light reflected and irradiated by the reflective mirror 200 may be incident on a rear surface of the display unit 151.

Furthermore, (d) of FIG. 15 shows a liquid crystal arrangement in which the electric field-dependent material charged in the electric field-dependent layer 1523 of the cholesteric liquid crystal layer 1520 is in a planar state. The planar state denotes a state in which a spiral axis of cholesteric liquid crystals is aligned substantially perpendicularly to a substrate, for example, the first electrode 1521 or the second electrode 1522. The liquid crystal layer 1523 in the planar state, which is an arrangement formed when a high electric field applied to liquid crystals in the homeotropic state is rapidly lowered, may reflect light of a specific wavelength among incident light according to a spiral structure of cholesteric liquid crystals when the cholesteric liquid crystals are in the planar state.

As an example, the spiral structure of the cholesteric liquid crystals may be formed to reflect polarized light in a first direction that can be transmitted through the polarizing filter 1510. Therefore, when an electric field applied to the first electrode 1521 and the second electrode 1522 is lowered, for example, when a voltage applied to the first electrode 1521 and the second electrode 1522 is minimized (a voltage off state), the liquid crystal layer 1520 may reflect polarized light in a first direction.

In this case, only polarized light in a first direction among light that passes through the display unit 151 and enters from a front surface of the display unit 151 through the polarizing filter 1510 disposed between the liquid crystal layer 1520 and the display unit 151, and thus when the polarized light in the first direction is reflected by the liquid crystal layer 1520, light entering from the front surface of the display unit 151 may be prevented from entering the device due to the polarizing filter 1510 and the liquid crystal layer 1520. Therefore, when the power of the artificial sky simulation apparatus 1200 is turned off, a shape inside the device may be prevented from being exposed through the display unit 151.

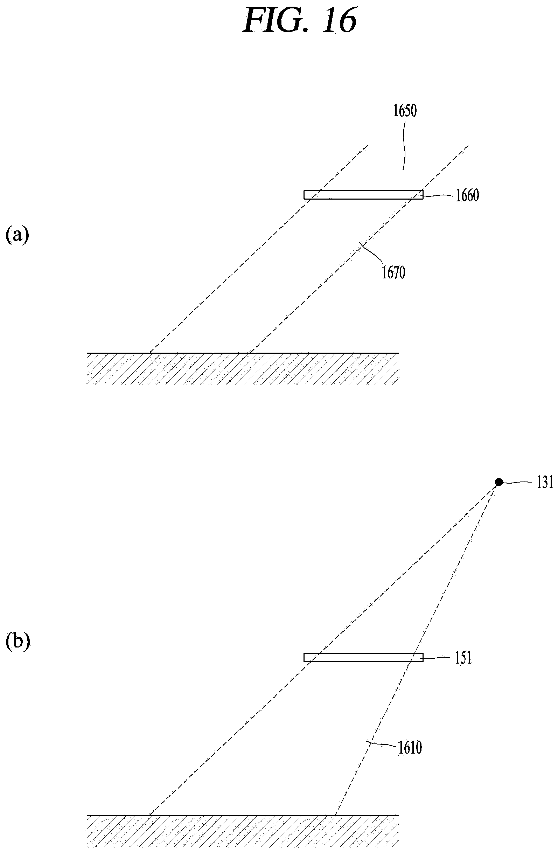

FIG. 16 is an exemplary view showing a difference in a shape of transmitted light and an irradiation area formed when a light source and natural light transmit through TOLED in an artificial sky simulation apparatus according to an embodiment of the present disclosure.

Conventionally, sunlight is irradiated in the form of straight light everywhere on the earth due to a distance between the sun and the earth. Therefore, in the case of actual natural light, as shown in (a) of FIG. 16, straight light may be irradiated to a rear surface of the display unit 151, and such straight light may not be dispersed according to a distance. Therefore, if natural light is irradiated to a rear surface of the display unit 151, then a shadow having the same size as an object displayed on the display unit 151 may be cast in an indoor space.

However, in the artificial sky simulation apparatus 1200 according to an embodiment of the present disclosure, light emitted from a light source is irradiated to a rear surface of the display unit 151, and light may be emitted in a cone shape with the light source unit 131 as a vertex, as shown in (b) of FIG. 16. Therefore, since it is not a straight light like sunlight as shown in (a) of FIG. 16, the light may be dispersed as it gets farther away from the light source unit 131 as shown in (b) of FIG. 16. In this case, when an object is displayed on the display unit 151, a shadow larger than the displayed object may be cast in the indoor space.

Meanwhile, such a dispersion of light is due to a distance from the light source, and when the distance between the light source and the display unit 151 is increased, the dispersion of light may be minimized. However, there is a problem in that a housing volume of the artificial sky simulation apparatus 1200 increases when a distance between the light source unit 131 and the display unit 151 is extended. Accordingly, the artificial sky simulation apparatus 1200 according to an embodiment of the present disclosure may extend a light path from the light source unit 131 to a rear surface of the display unit 151 by using at least one additional reflective mirror, thereby allowing more natural light, that is, light closer to straight light, to be irradiated to the rear surface of the display unit 151.

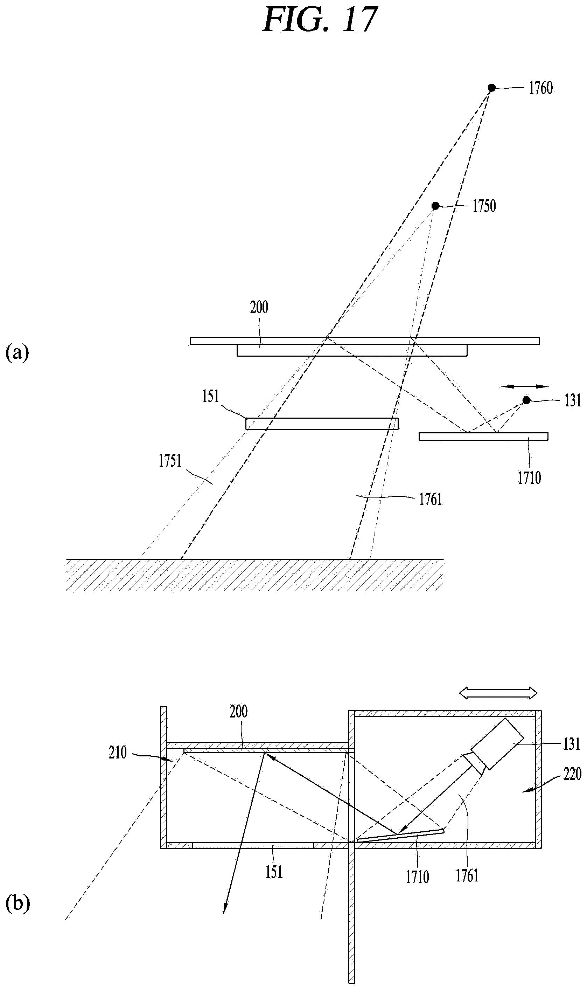

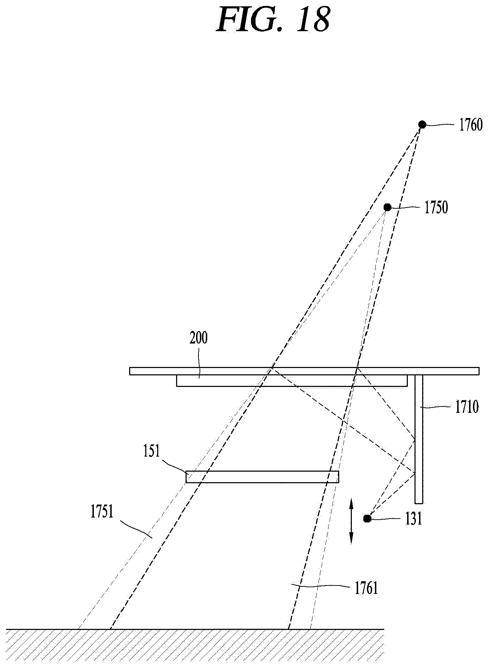

FIGS. 17 and 18 are exemplary views showing structures that allow light closer to sunlight to be formed by further using at least one reflective mirror in an artificial sky simulation apparatus according to an embodiment of the present disclosure.

First, referring to FIG. 17, (a) of FIG. 17 shows an example of a configuration in which an auxiliary reflective mirror 1710 is further disposed between the light source unit 131 and the reflective mirror 200. In this case, the auxiliary reflective mirror 1710 may be disposed in a direction in which at least part of the auxiliary reflective mirror 1710 faces the reflective mirror 200. Alternatively, one side of the auxiliary reflective mirror 200 may be disposed to be inclined inward, thereby reflecting light emitted from the light source unit 131 in a direction in which the reflective mirror 200 is disposed.

Accordingly, light emitted from the light source unit 131 is reflected on the auxiliary reflective mirror 1710, and a first reflected light reflected on the auxiliary reflective mirror 1710 may be reflected on the reflective mirror 200 to be irradiated to the rear surface of the display unit 151. That is, a light path from the light source unit 131 to the reflective mirror 200 may be further extended by using the auxiliary reflective mirror 1710.

In this case, a light path from the light source unit 131 to the rear surface of the display unit 151 may be further extended, and thus a dispersion width of the dispersed light may become narrower. That is, as shown in (a) of FIG. 17, compared to light (first light) 1751 irradiated into an indoor space through a rear surface of the display unit 151 from a first virtual light source 1750 disposed at a height corresponding to a light path distance when the auxiliary reflective mirror 1710 is not used, when the light path is extended using the auxiliary reflective mirror 1710, light (second light) 1761 irradiated into an indoor space through the rear surface of the display unit 151 from a second virtual light source 1760 disposed at a height corresponding to the extended light path distance may be light having a narrower dispersion width. That is, light more similar to straight light may be irradiated.

(b) of FIG. 17 shows an example in which the auxiliary reflective mirror 200 is disposed as described above in the artificial sky simulation apparatus 300 according to a first embodiment of the present disclosure. In this case, due to the auxiliary reflective mirror 1710, the light source unit 131 may be disposed in a direction of an upper surface of the display housing unit 210 rather than in a direction of a lower surface of the display housing 210. Accordingly, as shown in (b) of FIG. 17, the light source housing unit 220 may have a form that protrudes in a direction of an upper surface of the display housing unit 210.

Meanwhile, as shown in (b) of FIG. 17, when extending a light path using the auxiliary reflective mirror 1710, contact surfaces of the display housing unit 210 and the light source housing unit 220 as shown in FIGS. 2 and 3 may not be formed at an angle. However, a through hole through which the reflected light of the auxiliary reflective mirror 200 provided in the light source housing unit 220 can be transmitted may be disposed between the display housing unit 210 and the light source housing unit 220.

As shown above in FIG. 17, the configuration in which the auxiliary reflective mirror 200 is disposed in a direction facing the reflective mirror 200 has been described, but the auxiliary reflective mirror 200 may of course also be disposed in a different shape than that shown in FIG. 17. For example, the auxiliary reflective mirror 200 may be disposed in a direction perpendicular to the reflective mirror 200 as shown in FIG. 18.

Referring to FIG. 18, an artificial sky simulation apparatus 1200 according to an embodiment of the present disclosure may have an auxiliary reflective mirror 1710 disposed on an inner side of one of side surfaces of the light source housing unit 220. In this case, the auxiliary reflective mirror 1710 may be disposed in a vertical direction with respect to the reflective mirror 200. Furthermore, as described above, when the auxiliary reflective mirror 1710 is disposed in a vertical direction, the light source unit 131 may also be disposed to move in a vertical direction.

Accordingly, light emitted from the light source unit 131 is reflected on the auxiliary reflective mirror 1710, and a first reflected light reflected on the auxiliary reflective mirror 1710 may be reflected on the reflective mirror 200 to be irradiated to the rear surface of the display unit 151. That is, a light path from the light source unit 131 to the reflective mirror 200 may be further extended by using the auxiliary reflective mirror 1710. Accordingly, the light (second light) 1761 irradiated into an indoor space through a rear surface of the display unit 151 from the second virtual light source 1760 disposed at a height corresponding to the extended light path distance may be light having a narrower dispersion width. That is, light more similar to straight light may be irradiated.

However, when using the auxiliary reflective mirror 200 in this manner, at least part of the auxiliary reflective mirror 200 may be disposed to face the reflective mirror 200, and thus multiple reflections may occur between the two reflective mirrors facing each other.

Accordingly, the artificial sky simulation apparatus 1200 according to an embodiment of the present disclosure may prevent multiple reflections from occurring between the reflective mirror 200 and the auxiliary reflective mirror 200 using at least one polarizing plate and a wave plate while disposing the auxiliary reflective mirror 200.

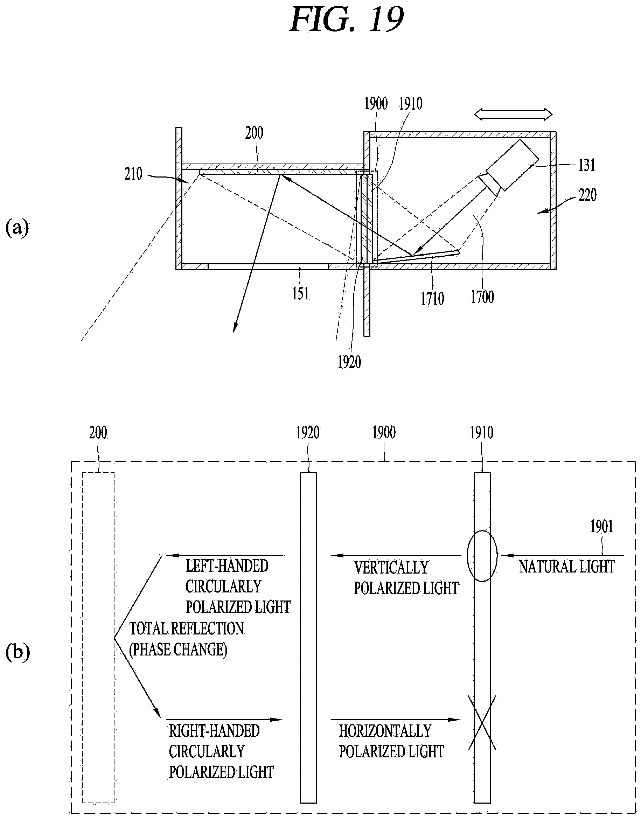

FIG. 19 is an exemplary view showing an example of a configuration including a polarizing plate and a wave plate to prevent multiple reflections occurring between reflective mirrors in an artificial sky simulation apparatus as described above.

First, as shown in (a) of FIG. 19, the polarizing plate 1910 and the wave plate 1920 may be disposed between the display housing unit 210 and the light source housing unit 220. In this case, the polarizing plate 1910 and the wave plate 1920 may be disposed in a through hole through which the reflected light of the auxiliary reflective mirror 200 can be transmitted. Therefore, the reflected light of the auxiliary reflective mirror 200 may transmit through the polarizing plate 1910 and the wave plate 1920 to reach the reflective mirror 200.

Meanwhile, a process of preventing multiple reflections through the polarizing plate 1910 and the wave plate 1920 is as shown in (b) of FIG. 19 below.

First, light emitted from the light source unit 131 may be reflected by the auxiliary reflective mirror 1710. In this case, light reflected by the auxiliary reflective mirror 1710 may be natural light 1901 in which light of a specific wavelength is not filtered out.

Then, natural light 1901 may transmit only light of a specific wavelength, that is, polarized light, through the polarizing plate 1910 while passing through the polarizing plate 1910. In this case, for convenience of explanation, if it is assumed that the polarizing plate 1910 is a vertical polarizing plate that transmits only vertically polarized light, only vertically polarized light may be transmitted through the polarizing plate 1910. Therefore, natural light 1901 may be converted into vertically linearly polarized light through the polarizing plate 1910, and the vertically linearly polarized light may be incident on the wave plate 1920.

Meanwhile, the wave plate 1920 may be a quarter wave plate (QWP). In this case, vertically polarized light incident on the QWP may be converted into left-handed circularly polarized light that rotates to the left. Then, light converted into left-handed circularly polarized light may reach the reflective mirror 200 to be reflected from the reflective mirror 200 and incident on a rear surface of the display unit 151.

However, part of the light reflected by the reflective mirror 200 may be incident from the reflective mirror 200 inward the display housing unit 210. In this case, since the reflective mirror 200 totally reflects light, when left-handed circularly polarized light is incident on the reflective mirror 200, right-handed circularly polarized light with a phase shift of 180 degrees may be reflected from the reflective mirror 200.

Then, the reflected light of the reflective mirror 200, that is, right-handed circularly polarized light, may be incident on the wave plate 1920, that is, the QWP. Then, right-handed circularly polarized light incident on the QWP may be converted into horizontally linearly polarized light. Furthermore, the horizontally linearly polarized light converted by the QWP may be incident on the polarizing plate 1910.

However, the polarizing plate 1910 may be a polarizing plate that can transmit only vertically linearly polarized light as described above. Therefore, it cannot transmit through the polarizing plate 1910. Therefore, natural light 1901 reflected from the auxiliary reflective mirror 200 may be transmitted to reach the reflective mirror 200, but reflected light reflected from the reflective mirror 200 in an opposite direction may not be transmitted through the QWP, that is, the wave plate 1920 and the polarizing plate 1910. Therefore, the reflected light reflected from the reflective mirror 200 does not reach the auxiliary reflective mirror 200 to prevent multiple reflections from occurring.

The foregoing present disclosure may be implemented as computer-readable codes on a program-recorded medium. The computer-readable medium may include any type of recording device in which data readable by a computer system is stored. Examples of the computer-readable medium include a hard disk drive (HDD), a solid state disk (SSD), a silicon disk drive (SDD), a ROM, a RAM, a CD-ROM, a magnetic tape, a floppy disk, an optical data storage device and the like, and also include a device implemented in the form of a carrier wave (for example, transmission via the Internet). In addition, the computer may include the control unit 100 of an artificial sky simulation apparatus according to an embodiment of the present disclosure.

The detailed description is therefore to be construed in all aspects as illustrative and not restrictive. The scope of the present disclosure should be determined by reasonable interpretation of the appended claims and all changes that come within the equivalent scope of the present disclosure are included in the scope of the present disclosure.

## Claims

1. An artificial sky simulation apparatus, the apparatus comprising:
a transparent display unit that displays at least one sky image;
a light source unit comprising a directional light source having a preset radiation angle;
a reflective mirror disposed on a rear surface of the transparent display unit to reflect light emitted from the light source; and
a control unit that controls the transparent display unit to display a sky image selected by a user from among the at least one sky image, and controls the light source unit to change the brightness and color temperature of the light source according to the selected sky image.

2. The apparatus of claim 1, wherein the light source unit further comprises:
a drive unit disposed to move the light source in a preset direction, and
wherein the drive unit comprises:
a rail disposed in the preset direction;
a mount mounted with the light source to face the reflective mirror, and disposed to fix the mounted light source; and
at least one wheel disposed to allow the mount to move on the rail and at least one drive motor to drive the wheel.

3. The apparatus of claim 2, wherein the drive unit further comprises:
a light source unit frame disposed to receive and support the light source and the drive unit, and
wherein the light source unit frame comprises:
a plurality of guide frames disposed to extend along the preset direction; and
a mount frame disposed to allow the plurality of guide frames to move along an extended direction and coupled to the mount.

4. The apparatus of claim 2, wherein the control unit calculates a position of the sun according to at least one of a selected sky image, a selected time, and a selected region, and moves a position of the light source according to the calculated position of the sun.

5. The apparatus of claim 1, wherein the transparent display unit is configured to: be received in a display housing unit disposed to receive and support the transparent display unit; be disposed with a hole of a size corresponding to at least part of a front surface of the transparent display unit to expose at least part of the front surface of the transparent display unit on a lower surface of the display housing unit; and be disposed with the reflective mirror extending along an upper surface of the display housing unit, and facing a rear surface of the transparent display unit on an inner side of the upper surface facing the lower surface of the display housing unit.

6. The apparatus of claim 5, wherein at least part of side surfaces of the display housing unit is provided with a light shield disposed to extend each side surface of the display housing unit.

7. The apparatus of claim 5, wherein each inner surface of the display housing unit is coated with a blackout layer not to expose a shape of the inner surface.

8. The apparatus of claim 5, further comprising:
a polarizing filter disposed between the transparent display unit and the reflective mirror to transmit polarized light in a first direction; and
a liquid crystal layer disposed between the polarizing filter and the reflective mirror to transmit light depending on whether a preset voltage is applied thereto.

9. The apparatus of claim 5, wherein one side of the reflective mirror is disposed to be inclined at a predetermined angle inward the display housing.

10. The apparatus of claim 5, wherein the light source unit is received in a light source housing unit disposed to receive and support the light source, and
wherein the light source housing unit further comprises at least one auxiliary reflective mirror disposed to reflect incident light at a specified reflection angle on the reflective mirror when light radiated from the light source is incident thereon.

11. The apparatus of claim 1, further comprising:
an audio output unit disposed to output an audio signal corresponding to a sky image selected by the user,
wherein the audio signal corresponding to the selected sky image is an audio signal in which a plurality of different audio signals are combined differently in at least one of an output order and a delay time according to the user's selection.

12. The apparatus of claim 1, further comprising:
a communication unit for controlling at least one peripheral device capable of adjusting temperature, humidity and wind of an indoor space in which the artificial sky simulation apparatus is disposed,
wherein the control unit controls at least one peripheral device to change at least one of the temperature, humidity, and wind of the indoor space according to a sky image selected by the user.

13. The apparatus of claim 12, wherein the control unit controls, when a specific region is selected, the transparent display unit to acquire a current weather condition of the specific region, and output a sky image corresponding to the acquired weather information, and controls at least one peripheral device to change at least one of temperature, humidity and wind of the indoor space based on weather information of the specific region.

14. The apparatus of claim 13, wherein a sky image corresponding to the weather information of the specific region comprises at least part of a landmark of the specific region.

15. The apparatus of claim 13, wherein the control unit calculates a difference between at least one of temperature, humidity, and wind speed according to weather information of the specific region, and at least one of temperature, humidity, and wind speed of the indoor space, and determines a control level for controlling the at least one peripheral device by reducing the calculated difference according to a preset reduction ratio.

16. The apparatus of claim 13, wherein the control unit calculates, when the user selects a specific time, a solar altitude corresponding to the selected time in the specific region based on the selected time and a latitude of the specific region, and controls the at least one peripheral device to change at least one of the temperature, humidity, and wind of the indoor space according to the calculated solar altitude.

17. A method of controlling an artificial sky simulation apparatus comprising a directional light source and a transparent display unit disposed to transmit light from the light source, the method comprising:
outputting a selected specific sky image to the transparent display unit;
changing at least one of the brightness and color temperature of the light source according to the specific sky image;
changing a position at which light from the light source is transmitted through the transparent display unit based on the specific sky image;
outputting an audio signal corresponding to the specific sky image; and
controlling at least one peripheral device based on the specific sky image to change at least one of temperature, humidity, and wind of an indoor space in which the artificial sky simulation apparatus is installed.

18. The method of claim 17, wherein the outputting of the specific sky image comprises:
selecting a specific region from a user; and
outputting a sky image corresponding to the selected region as the specific sky image, and
wherein the changing of at least one of the temperature, humidity, and wind comprises:
calculating a solar altitude corresponding to a time selected by the user according to a latitude of the specific region; and
controlling the at least one peripheral device to change at least one of the temperature, humidity, and wind of the indoor space according to the calculated solar altitude.

19. The method of claim 17, wherein the outputting of the specific sky image comprises:
selecting a specific region from a user; and
outputting a sky image corresponding to the selected region as the specific sky image, and
wherein the changing of at least one of the temperature, humidity, and wind comprises:
detecting a current weather condition of the specific region;
calculating a difference between the current weather condition of the detected specific region and at least one of the temperature, humidity, and wind of the indoor space;
determining a control level to control at least one of the temperature, humidity, and wind according to the calculated difference and a preset reduction ratio; and
controlling the at least one peripheral device according to the determined control level to change at least one of the temperature, humidity, and wind of the indoor space.
